# EUROPEAN PATENT APPLICATION

(11) **EP 4 614 562 A1**
(43) Date of publication of application: **10.09.2025**
(21) Application number: 25157913.2
(22) Date of filing: 14.02.2025
(51) Int. Cl.: H01L 23/367, H01L 23/473

(54) **PACKAGED COLD PLATE LIDS FOR OPTIMIZED COOLING OF HIGH POWER CHIP PACKAGES AND SYSTEMS AND METHODS INCORPORATING SAME**

(30) Priority: 16.02.2024 US 202463554628 P; 07.02.2025 US 202519048367
(71) Applicant: Google LLC, Mountain View, CA 94043 (US)
(72) Inventor: Mohammed, Ilyas, Mountain View, California, 94043 (US)
(74) Representative: Betten & Resch

(57) **Abstract**

A semiconductor chip package includes a package substrate, at least one semiconductor chip, and a cold plate lid. The cold plate lid may be configured to cool the at least one semiconductor chip and minimize warpage of the package substrate. The cold plate lid may be bonded to the package substrate and thermally bonded to the rear surface of the at least one semiconductor chip. The cold plate lid further comprises an outer housing, a fluid inlet and a fluid outlet, and a flow plate. The outer housing may define an interior space and have a bottom surface bonded to the at least one semiconductor chip. The flow plate divides the interior space into an upper chamber and a lower chamber. Fluid flows from the upper chamber through apertures in the flow plate and into the lower chamber in a direction perpendicular to the rear surface of the semiconductor chip.

## Description

### CROSS-REFERENCE TO RELATED APPLICATIONS

The present application claims the benefit of the filing date of U.S. Provisional Patent Application No. 63/554,628, filed February 16, 2024, the disclosure of which is hereby incorporated herein by reference.

### BACKGROUND

Semiconductor devices ranging from very low power (milli-Watts) to very high power (kilo-Watts) devices generate heat during use. Low power devices can be found in battery-powered devices such as watches and phones and high power devices can be found in high-compute environments such as data centers. Regardless of whether a semiconductor device is high or low power, semiconductor devices must be kept within their operating temperature range to properly function. The maximum operating temperature is typically around 100°C, ranging from typically 85°C to 130°C. A high powered device generates significant amounts of heat and requires an efficient cooling system to maintain its temperature within optimal operating range. The cooling system functions to transfer heat from the semiconductor device to another location where it can dissipate or diffuse heat, such as ambient air through the use of a radiator or a fan.

Various cooling solutions and systems exist to cool semiconductor devices based on their power output, system application, usage environment, and the like. A common solution is to attach a heatsink made of a high thermal conductivity material, such as copper, on top of the semiconductor chip. The heatsink is also designed to have a large surface area through fins or pins so that a large hot surface area is exposed to the air. A fan may blow air across the heatsink to carry the heat away from the heatsink, thereby maintaining the chip temperature within desirable range. In other solutions, a cold plate with an inlet and outlet for a cooling liquid is attached to the chip. A cold plate is commonly made from a high thermal conductivity material to enable liquid flowing through the cold plate to transfer the heat away.

### BRIEF SUMMARY

A cooling system incorporated into a microelectronic package, such as a semiconductor chip package, is disclosed. The cooling system may be a cold plate lid designed to be a package lid with one or more fluid chambers and cooling elements, such as fins, microchannels, or other cooling features within the cold plate lid. In one example, the cooling system is a leak-proof cooling system that overlies a substrate and microelectronic elements in the package, such as one or more semiconductor chips. The cooling system may be bonded to the package substrate, as well as thermally attached to the one or more chips in the chip package. A thermally conductive material, such as a thermal interface material, may be used to join the cooling system directly to the microelectronic elements. Additionally, the cooling system can be further designed so that liquid flow to the interior bottom surface of the cooling system, which directly overlies the microelectronic elements in the package, is in a substantially perpendicular direction, such that there is perpendicular fluid flow toward the interior bottom surface. Further, microjets or nozzles within the apertures can provide greater control over fluid flow. In some examples, assembling the cold plate lid as part of the chip package requires only a single layer of thermal interface material to be positioned between the cold plate lid and the microelectronic elements. The overall design can reduce thermal resistance of the cooling liquid in the second heat exchange chamber that directly flows over the microelectronic elements. In some examples, the cold plate lid can additionally provide structural features to help minimize or prevent warping of the chip due to high temperatures generated by high powered processing chips, as well as warping due to differing coefficients of thermal expansion between the package substrate and the one or more chips in the package.

According to an aspect of the disclosure, a semiconductor chip package includes a package substrate, at least one integrated circuit or semiconductor chip, and a cold plate lid configured to cool the at least one semiconductor chip and minimize warpage of the package substrate. The substrate may have terminals disposed at a surface. The cold plate lid may be bonded to the package substrate and thermally attached to the at least one semiconductor chip. The cold plate lid may further include an interior space; a fluid inlet; a fluid outlet in communication with the interior space; a base plate thermally attached to the at least one semiconductor chip; and a flow plate positioned within the interior space and overlying the base plate. The flow plate may have a plurality of inflow apertures that extend between top and bottom surfaces of the flow plate so that fluid flowing within the interior space may flow through the apertures and in a direction perpendicular to the base plate.

According to another aspect of the disclosure, a system includes a printed circuit board and a semiconductor chip package, the semiconductor package include a package substrate having terminals disposed at a surface and bonded to the printed circuit board; at least one semiconductor chip; and a cold plate lid configured to cool the at least one semiconductor chip and minimize warpage of the package substrate. The cold plate lid may be bonded to the package substrate and thermally attached to the at least one semiconductor chip. The cold plate lid may further include an interior space; a fluid inlet and a fluid outlet in communication with the interior space; a base plate thermally attached to the at least one semiconductor chip; and a flow plate positioned within the interior space and overlying the base plate. The flow plate may have a plurality of inflow apertures that extend between top and bottom surfaces of the flow plate so that fluid flowing within the interior space may flow through the apertures and in a direction perpendicular to the base plate.

According to another aspect of the disclosure, a chip package includes a chip subassembly and a cooling system. The chip subassembly includes a package substrate; terminals disposed at a surface of the package substrate; and a reconstituted wafer. The reconstituted wafer may be bonded to the package substrate and further include a plurality of semiconductor chips embedded within an overmold. The cooling system may be bonded to the package substrate of the chip subassembly and thermally attached to a rear surface of at least one of the plurality of semiconductor chips. The cooling system may include a main body that includes a base plate, a top plate and an intermediate flow plate. The main body may have a major surface overlying the rear surface of the at least one of the plurality of semiconductor chips. The top plate may overlie the base plate. The intermediate flow plate may be positioned between the top and base plates. The intermediate flow plate may include a plurality of inflow apertures that extend between the top and bottom surfaces of the intermediate flow plate so that fluid flowing across intermediate flow plate may flow through the inflow apertures and in a direction perpendicular to the base plate.

According to another aspect of the disclosure, a method of manufacturing a chip package includes attaching first and second semiconductor chips to a carrier substrate; applying a thermal interface material to a bonding surface of the first and semiconductor chips; bonding a cold plate lid to the bonding surface of the first and second semiconductor chips; filling a space between exposed surfaces of the carrier substrate and a bottom surface of the cold plate lid and adjacent edges of the first and second semiconductor chips with an overmold; removing the carrier substrate; and providing terminals to the chip package.

According to another aspect of the disclosure, a semiconductor chip package includes a package substrate, at least one semiconductor chip, and a cold plate lid. The package substrate includes terminals disposed at a surface. The at least one semiconductor chip has a front surface bonded to the package substrate and an opposed rear surface. The cold plate lid may be configured to cool the at least one semiconductor chip and minimize warpage of the package substrate. The cold plate lid may be bonded to the package substrate and thermally bonded to the rear surface of the at least one semiconductor chip. The cold plate lid further comprises an outer housing, a fluid inlet and a fluid outlet, and a flow plate. The outer housing may define an interior space and have a bottom surface bonded to the at least one semiconductor chip. The fluid inlet and the fluid outlet may be in communication with the interior space. The flow plate may be positioned within the interior space and divide the interior space into an upper chamber and a lower chamber. The flow plate may have a plurality of inflow apertures that extend between the top and bottom surfaces of the flow plate so that fluid flowing into the interior space flows from the upper chamber through the apertures and into the lower chamber in a direction perpendicular to the rear surface of the semiconductor chip.

According to another aspect of the disclosure, a system includes a printed circuit board and a semiconductor chip package with terminals are bonded to the printed circuit board. The semiconductor chip package includes a package substrate, at least one semiconductor chip, and a cold plate lid. The package substrate includes terminals disposed at a surface. The at least one semiconductor chip has a front surface bonded to the package substrate and an opposed rear surface. The cold plate lid may be configured to cool the at least one semiconductor chip and minimize warpage of the package substrate. The cold plate lid may be bonded to the package substrate and thermally bonded to the rear surface of the at least one semiconductor chip. The cold plate lid further comprises an outer housing, a fluid inlet and a fluid outlet, and a flow plate. The outer housing may define an interior space and have a bottom surface bonded to the at least one semiconductor chip. The fluid inlet and the fluid outlet may be in communication with the interior space. The flow plate may be positioned within the interior space and divide the interior space into an upper chamber and a lower chamber. The flow plate may have a plurality of inflow apertures that extend between the top and bottom surfaces of the flow plate so that fluid flowing into the interior space flows from the upper chamber through the apertures and into the lower chamber in a direction perpendicular to the rear surface of the semiconductor chip. The flow plate further includes an inflow region, an outflow region, and a flow wall separating the inflow and outflow regions.

According to another aspect of the disclosure, a chip package includes a chip subassembly and a cooling system. The chip subassembly includes a package substrate, terminals disposed at a surface of the package substrate, and a plurality of semiconductor chips that each have a top surface, an opposed rear surface, and edges extending therebetween. The cooling system may be bonded to the package substrate of the chip subassembly and thermally bonded to rear surfaces of the plurality of semiconductor chips. The cooling system may include a main body that includes a base plate, a top plate and an intermediate flow plate. The base plate may have a major surface bonded to the rear surfaces of the plurality of semiconductor chips and a circumferential edge laterally adjacent and extending around the plurality of semiconductor chips. The top plate may overlie the base plate. The intermediate flow plate may be positioned between the top and base plates and have a plurality of inflow apertures that extend between top and bottom surfaces of the intermediate flow plate so that fluid flowing across intermediate flow plate may flow through the inflow apertures and in a direction perpendicular to the base plate.

### BRIEF DESCRIPTION OF THE DRAWINGS

A more complete appreciation of the subject matter of the present technology may be realized by reference to the following detailed description which refers to the accompanying drawings, in which:
FIG. 1 is a schematic cross-sectional view of an example chip package according to an aspect of the disclosure.
FIGS. 2A-2C depict schematic example arrangements of apertures within the cold plate lid of FIG. 1 according to aspects of the disclosure.
FIG. 3 is a schematic cross-sectional view of a semiconductor chip package according to an aspect of the disclosure.
FIG. 3A is an enlarged area of FIG. 3.
FIG. 4 is another schematic cross-sectional view of a semiconductor chip package according to an aspect of the disclosure.
FIG. 5 is a bottom perspective view of a semiconductor chip package according to an aspect of the disclosure.
FIG. 6 is a schematic cross-sectional view of the chip package of FIG. 5.
FIG. 7 is a perspective view of a chip subassembly of the chip package of FIG. 5.
FIGS. 8A-8B are perspective top and bottom views of a cold plate lid of the chip package of FIG. 5.
FIG. 9 is a top perspective cutaway view of the cold plate lid of FIGS. 8A-8B.
FIGS. 10A-10B are perspective top and bottom views of a base plate of the cold plate lid of FIGS. 8A-8B.
FIGS. 11A-11B are perspective top and bottom views of an example intermediate flow plate of the cold plate lid of FIGS. 8A-8B.
FIGS. 12A-12B are perspective top and bottom views of an example top plate of the cold plate lid of FIGS. 8A-8B.
FIG. 13 is a top perspective cutaway view of the chip package shown in FIG. 5.
FIG. 14 is a schematic cross-sectional view of an example chip package according to an aspect of the disclosure.
FIGS. 14A-14G illustrates a method of manufacturing the chip package of FIG. 14 according to an aspect of the disclosure.
FIG. 14H illustrates chip package of FIG. 14 being further attached to another component.
FIG. 15 is a schematic cross-sectional view of an example chip package according to an aspect of the disclosure.
FIGS. 15A-15E illustrate a method of manufacturing the chip package of FIG. 15 according to an aspect of the disclosure.
FIG. 16 is a is a cross-sectional view of another chip package according to an aspect of the disclosure.

### DETAILED DESCRIPTION

Semiconductor chips within high compute microelectronic packages generate a significant amount of heat that can impact the integrity of the chips and other components within the chip package. To aid in dissipation of heat generated by such chips, an improved chip package is disclosed that incorporates and integrates a cooling system directly into the chip package. This can lead to greater ease during assembly of the chip package to another component or main board, as well as provide enhanced cooling of chips within the chip package.

The chip package system can include two primary components: a chip subassembly that includes one or more multiple high power chips, and a cooling system, such as a cold plate lid described herein. In some examples, the chip subassembly may include a reconstituted wafer or panel that includes a plurality of semiconductor chips that are embedded in an overmold. The reconstituted wafer may be bonded to a package substrate. A cooling system, such as a cold plate lid, may be bonded to the package substrate and also be in thermal communication with microelements.

The cooling system may be a cold plate lid designed to be a package lid with one or more fluid chambers and cooling elements, such as fins, microchannels, or other cooling features within the cold plate lid. The cooling system may be a leak-proof cooling system and, in some examples, may be directly bonded to the package substrate, as well as thermally attached and in contact with one or more chips in the chip package. In other examples, the cooling system may be bonded to another component, such as the overmold of the reconstituted wafer, which may be positioned between the cooling system and the package substrate. A thermally conductive material, such as a thermal interface material, may be used to join the cooling system directly to one or more microelectronic elements or chips in the chip package.

The cooling system can be further designed so that liquid flow to the interior bottom surface of the cooling system, which directly overlies the microelectronic elements in the package, flows in a substantially perpendicular direction, such that there is perpendicular fluid flow toward the interior bottom surface. Further, microjets or nozzles positioned within the apertures or at an end of the apertures can provide greater control over fluid flow. In some examples, assembling the cold plate lid as part of the chip package requires only a single layer of thermal interface material to be positioned between the cold plate lid and the microelectronic elements. The overall design can further reduce thermal resistance of the cooling liquid that flows through the portion of the cold plate lid that overlies the chips in the chip package. In some examples, the cold plate lid can provide structural features that help to minimize or prevent warping of the chip due to high temperatures generated by high powered processing chip, as well as warping due to differing coefficients of thermal expansion between the package substrate and the one or more chips in the package.

The cold plate lid may include several interior chambers. For example, the cold plate lid may include an inflow chamber through which cooling liquid will flow, a heat exchange chamber which will overlie surfaces of chips in the package and transfer heat in the heat exchange chamber to the fluid flowing through heat exchange chamber, and an outflow chamber where the now heated liquid will exit the cold plate lid. In one example, cooling fluid may flow through an inlet of the cold plate lid into an inflow chamber. Fluid in the first inflow chamber may flow through apertures in a flow plate that overlies the heat exchange chamber. Fluid flowing through the apertures in the flow plate may flow in a perpendicular direction toward the interior bottom surface of the cold plate lid, which may overlie chips in the chip package. The interior bottom surface may further include cooling elements, such as fins or channels, that may extend from or be positioned within the base plate. The speed of the fluid and amount of fluid flowing through the apertures can be modified. Aside from modifying characteristics of the apertures, such as size, profile, and number of apertures, microjets or nozzles may also be provided within or at the apertures. Nozzles can help to increase the speed of perpendicular fluid flow, such that the rate of perpendicular flow is greater than fluid flow throughout the rest of the cooling system. The size of the apertures may also be modified to allow increased flow through certain apertures as compared to others. Additionally, nozzles can be provided a short distance from the bottom surface of the cold plate lid. These features can help to further spot-cool the microelectronic elements in the package and are further incorporated into the cold plate lid design.

The overall design both reduces the thermal resistance of the cooling liquid in the heat exchange chamber that directly flows over the microelectronic elements and also provides the mechanical advantage of a lid to prevent warping of the chip due to high temperatures.

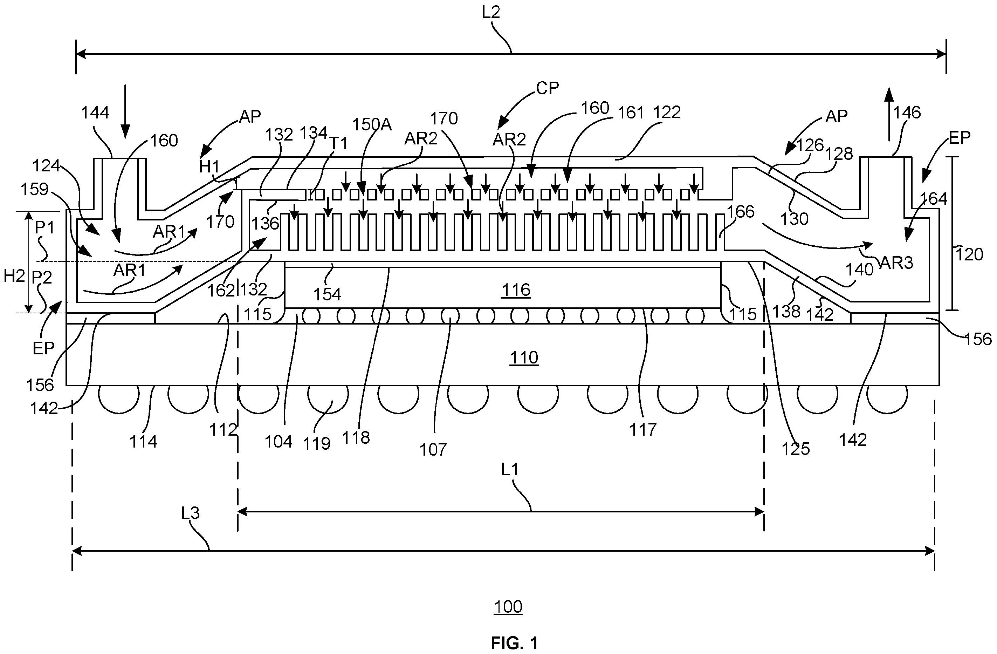

FIG. 1 is a microelectronic package 100 according to an aspect of the disclosure. The package 100 includes a package substrate 110 having a top surface 112, a bottom surface 114, at least one microelectronic element 116 bonded to package substrate 110, and cooling system 120, which in this example is a cold plate lid 122. Cooling system 120 overlies package substrate 110 and the at least one microelectronic element 116. Cooling system 120 may be bonded directly to package substrate 110 and thermally joined to the at least one microelectronic element 116. In other examples, cooling system 120 may be indirectly bonded to package substrate 110. The at least one microelectronic element 116 may be bonded to package substrate 110 with solder balls 107 or any other interconnection. An underfill 104 may be provided in the space between solder balls 107. For ease of discussion, the at least one microelectronic element 116 will be referred to herein as microelectronic element or semiconductor chip 116, but it is to be appreciated that microelectronic element 116 may be more than one microelectronic element or chip such as two or more, or three or more, or four or more.

Cooling system 120 can provide enhanced cooling of microelectronic element 116 by controlling the direction of fluid flow within cooling system 120. For example, the direction of fluid flow to apertures in an intermediate plate can be controlled, as well as the speed, amount, and direction of fluid flow to a surface of the cooling system 120 directly overlying the at least one microelectronic element 116. Thermal resistance may also be reduced due to the structure of cold plate lid 122 and the presence of only one thermal interface connection between cooling system 120 and microelectronic element 116. Terminals, such as solder balls 119, may be disposed at package substrate 110 and allow for interconnection of the packaged microelectronic element 116, with cooling system 120, to another device, such as a printed circuit board or the like.

Cooling system 120 may be a cold plate lid 122 that can include one or more functions, such as a lid function, a cold plate function, and a stiffener function. In this example, cold plate lid 122 fully encloses microelectronic element 116, which may be a high powered semiconductor chip that generates significant heat. Cold plate lid 122 can help to dissipate and/or cool heat emanating from microelectronic element 116 and also provide a cooling function to cool down microelectronic element 116. In this example, cooling can be accomplished, in part, by controlling the direction of fluid flow within interior portion 124 of cold plate lid 122.

Cold plate lid 122 may have an integrally formed top plate 126, intermediate flow plate 132, and base plate 138, each having a respective top surface 128, 134, 140 and a respective bottom surface 130, 136, 142. In other examples, some of which will be described herein, one or more of top plate 126, base plate 138, and intermediate flow plate 132 may be individual or separate plates joined to one of the other plates. Cooling system 120 may include an inlet 144 for the introduction of fluid into cold plate lid 122 and an outlet 146 to expel fluid that has been heated. The plates collectively forming cold plate lid 122 may be formed from the same or different materials. In one example, top plate 126 and intermediate flow plate 132 may be manufactured made from any suitable materials, such as metals, ceramics, glass, plastics, and the like. Base plate 138, which will be in close proximity to microelectronic element 116, may be comprised of a thermally conductive material to assist with the transfer of heat into cold plate lid 122. Non-limiting examples of thermally conductive materials can include copper, diamond, a ceramic, such as aluminum nitride or silicon carbide, or any other desired thermally conductive material or combination of materials. In some examples, a diamond layer may be coated over a metal surface.

Intermediate flow plate 132 may be positioned between top plate 126 and base plate 138, and more particularly between top surface 140 of base plate 138 and bottom surface 130 of top plate 126. In this example, intermediate flow plate 132 has a length L1 that is less than length L2 of top plate 126 and length L3 of base plate 138. Apertures 150A may extend through top surface 134 and bottom surface 136 of intermediate flow plate 132.

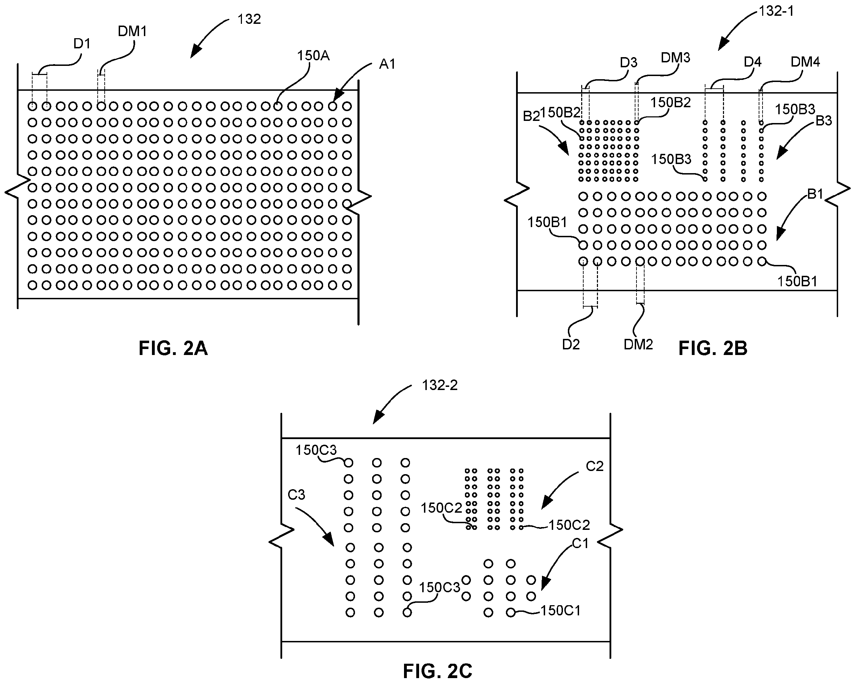

Apertures 150A within intermediate flow plate 132 may be arranged and configured in numerous variations to control the areas in which fluid will directly contact top surface 140 of base plate 138 and/or the speed of fluid flowing through apertures 150A. Apertures 150A may be uniformly distributed across intermediate flow plate 132. For example, as shown in FIG. 2A, a schematic representation of a top view of a portion of intermediate flow plate 132 is shown without the remainder of the other plates and components of cooling system or cold plate lid 122 for ease of discussion. A single array A1 of apertures 150A is shown evenly spaced apart from one another by a center-to-center distance D1 and having a same diameter DM1. In this example, array A1 is a 12x24 array of apertures 150A. FIG. 2B shows another example schematic representation of a portion of another intermediate flow plate 132-1 that can be implemented with cold plate lid and which includes multiple arrays with different center-center distances, aperture sizes, and configurations. As shown, three arrays B1, B2, B3 of respective apertures 150B1, 150B2, and 150B3 are shown dispersed across a section of the flow plate 132-1. Aperture array B1 is similar to array A1 of FIG. 2A, but includes a 5x14 array of apertures 150B1. Array B2 includes an 8x8 array of apertures 150B2. Array B3 includes an 8x4 array of apertures 150B3. The center-to-center distance D2 between apertures 150B1 in array B1, center-to-center distance D3 between apertures 150B2 in array B2, and center-to-center distance D4 between apertures 150B3 in array B3 may differ. As shown, the center-to-center distances D2, D3, and D4 each differ, with center-to-center distance D4 being greater than center-to-center distances D2 and D3. The diameters of apertures in the arrays also may differ. For example, diameter DM2 of apertures 150B1 in array B1 is greater than diameter DM3 of apertures 150B2 in array B2 and greater than diameter DM4 of apertures 150B3 in array B3.

FIG. 2C illustrates another example configuration of apertures within another intermediate flow plate 132-2. As shown, arrays C1, C2, C3 of corresponding apertures 150C1, 150C2, 150C3 are arranged across intermediate flow plate 132-2. Array C1 of apertures 150C1 includes four vertical rows of apertures 150C1, where each row contains either two apertures or four apertures and that collectively form the shape of a cross. Array C2 is composed of three smaller 8x2 arrays of apertures 150C2. The three smaller arrays may be spaced apart from one another. Array C3 is a 10x3 array of apertures 150C3 that extend along a width of an intermediate flow plate. These represent non-limiting examples of possible arrangements of apertures on an intermediate flow plate, but numerous other configurations may be implemented.

With reference back to FIG. 1, each aperture 150A is shown as having a constant diameter through a thickness T1 of intermediate flow plate 132 between top surface 134 and bottom surface 136 of intermediate flow plate 132. In other examples, a diameter of one or more apertures 150A may differ to increase or decrease a velocity of fluid as the fluid exits aperture 150A through bottom surface 136 of intermediate flow plate 132. For example, aperture 150A may instead taper as the aperture extends through thickness T1, such that a diameter of an aperture at a top surface of a flow plate is greater than a diameter of an aperture at a bottom surface of a flow plate or vice versa.

Cooling system 120 may be joined to microelectronic element 116. As shown, microelectronic element 116 includes a rear surface 118, an opposed active and front surface 117, and opposed edge surfaces 115 extending between respective front and rear surfaces 117, 118. Microelectronic element 116 may be a semiconductor chip, as discussed further below. A thermal interface material 154 can be used to join cooling system 120 to microelectronic element 116. As shown, bottom surface 142 of base plate 138 is also the bottom surface 125 of the overall cooling system 120. Bottom surface 125 of cooling system 120 includes plate 138, which overlies rear surface 118 of microelectronic element 116. In this example, a thermal interface material ("TIM") 154 may be applied between bottom surface 142 of cooling system 120 and rear surface 118 of microelectronic element 116 to enhance thermal coupling and improve the heat transfer between these two surfaces. TIM 154 may include phase change materials, gap fillers, thermal grease, and the like, but any desired TIM 154 materials can be used. In some examples, a high thermally conductive material may be used for TIM 154.

Cooling system 120, which in this example is also cold plate lid 122, may have a bridge-like cross-sectional profile. Cold plate lid 122 includes peripheral end portions EP that extend around edges 115 of microelectronic element 116. Peripheral end portion EP and bottom surface 142 of cold plate lid 122 may be bonded to package substrate 110 using a bonding material 156, such as, for example, an adhesive. The portion of cold plate lid 122 overlying microelectronic element 116 may be a central portion CP that extends along a first plane P1 that is parallel to a second plane P2 along which peripheral end portion EP extends. Central portion CP extends along a different plane P1 than peripheral end portion EP, and is higher and/or at a different elevation than plane P2 to accommodate the presence of microelectronic element 116 in package 100. Angled portions AP extend between and join peripheral ends EP and central portion CP, but in other examples may not be angled. Bonding of cold plate lid 122 to package substrate 110 incorporates cooling system 120 into the chip package. That is, cold plate lid 122 is now integrally formed as part of chip package 100, which can be later joined to a main board.

Cold plate lid 122 may include three flow regions or chambers created by intermediate flow plate 132: an inflow chamber 160; a heat exchange chamber 162; and an outflow chamber 164. Inflow chamber region 160 begins at inlet 144 and extends through end portion EP and central portion CP of cold plate lid 122 that overlies intermediate plate 132. Heat exchange chamber 162 can include a plurality of cooling elements 166, which in this example are integrally formed, thermally conductive, and extend upwardly from top surface 140 of base plate 138 toward top plate 126. Cooling elements 166 can be any elements that help to further distribute heat generated by microelectronic element 116, such as pin fins. In this example, cooling elements 166 are integrally formed with cold plate lid 122, but in other examples, they may be separately formed and joined to cold plate lid 122. Outflow chamber 164 can begin where fluid exits heat exchange chamber 162 and terminates at the opening of outlet 146.

Cold plate lid 122 can be further configured to direct the flow of cooling fluid to intermediate flow plate 132. In this example, an inlet 144 is positioned at an outermost end of cold plate lid 122 and an outlet 146 is positioned at an opposite end. Cooling fluid may flow through inlet 144 into a first portion 159 of inflow chamber 160. First portion 159 may be filled with cooling fluid, which may flow in the direction of arrows AR1 into second portion 161 of inflow chamber 160 through opening 170 created between an outer edge of top surface 134 of intermediate flow plate 132 and bottom interior surface 130 of top plate 126 of cold plate lid 122. Cooling fluid from first portion 159 of inflow chamber 160 is forced through opening 170 and into second portion 161 of inflow chamber 160. The smaller opening 170 can cause fluid to increase in speed as it flows from first portion 159 into second portion 161 of inflow chamber 160.

Second portion 161 of inflow chamber 160 may overlie intermediate flow plate 132. In this example, second portion 161 may have a height H1, that is significantly smaller than height H2 of first portion 159. This allows for second portion 161 to be filled with cooling fluid, such that cooling fluid will overlie all apertures 150A of intermediate flow plate 132. Fluid flows into apertures 150A that directly overlie heat exchange chamber 162. This configuration helps to ensure that cooling fluid entering apertures 150A will flow in a direction of arrow AR2 that is perpendicular or substantially perpendicular to a major surface of microelectronic element 116, which in this example are the front and rear surfaces 117,118 of microelectronic element 116.

When fluid flows into heat exchange chamber162, heat exchange between heat in the cold plate and the fluid can occur. For example, heat that has been thermally transferred from microelectronic element 116 into cold plate lid 122, including heat transferred through TIM 154, will be transferred into the fluid within heat exchange chamber 162. Controlling the direction of fluid flowing into heat exchange chamber 162, and particularly controlling the flow of fluid in a direction perpendicular to a surface of cold plate lid 122, helps to ensure cooling of a surface of cold plate lid 122 that directly overlies rear surface 118 of microelectronic element 116, to which cold plate lid 122 is attached. The flow of fluid into heat exchange chamber 162 can be further controlled by adjusting the size and/or shape of the apertures 150A. For example, as previously discussed, diameter DM1 (FIG. 2A) may be adjusted to increase or decrease the amount of fluid flowing through each aperture. For example, flow rate can be increased to cool parts of the chip that have high heat dissipation by changing the diameter of the apertures, density of apertures, and the like. In some examples, aperture diameter DM1 may be between 0.1 mm and 0.5 mm. In other examples, aperture diameter DM1 may be between 0.5 mm and 2.5 mm. In other examples, aperture diameter DM1 may be between 0.2 mm and 0.4 mm. In still other examples, aperture diameter DM1 may be between 0.1 mm and 2.5 mm. In still other examples, aperture diameter DM1 may be less than 0.1 mm or greater than 0.5 mm, or greater than 1.0 mm, or greater than 2.5 mm. Further, as previously discussed, the shape and/or profile through a thickness of intermediate flow plate 132 can be adjusted to further modify amount and speed of flow through each aperture 150A.

Fluid flowing into heat exchange chamber 162 will contact top surface 140 of base plate 138, which is also bottom surface 125 of heat exchange chamber 162. Because fluid will be flowing in a perpendicular direction to top surface 140 of base plate 138, this helps to increase direct cooling of microelectronic element 116 and heat transferred into cold plate lid 122. Fluid within heat exchange chamber 162 will flow laterally through cold plate lid 122 and through heat exchange chamber 162. Heated fluid will then flow in the direction of arrow AR3 and exit heat exchange chamber 162 and will transition into outflow chamber 164 where heated liquid will collect and pass through outlet 146.

A first or inflow chamber 160 may be formed in the gap or space between top plate 126 and top surface 134 of second or intermediate flow plate 132, and a second heat exchange chamber 162 may be formed in the space between bottom surface 136 of flow plate 132 and top surface 140 of base plate 138. In use, cooling liquid may flow through inlet 144 into cooling system 120, and particularly into inflow chamber 160 of cold plate lid 122. Fluid within inflow chamber 160 will flow through apertures 150A in intermediate flow plate 132 and into heat exchange chamber 162. Fluid flowing through apertures 150A and intermediate flow plate 132 may flow in a perpendicular direction toward base plate 138 and any cooling elements in heat exchange chamber 162, such as fins or channels, may extend or be positioned within base plate 138. The speed of the fluid and amount of fluid flowing through the apertures 150A can be modified by varying the number, type, size, and location of the apertures. Additionally, as will be described in more detail below, nozzles may optionally be provided within or at the apertures to increase the speed of perpendicular fluid flow, such that the rate of perpendicular flow is greater than the rate of fluid flow throughout the rest of the cooling system. The size of the apertures may also be modified to allow increased flow through certain apertures as compared to others. These features can help to further spot cool or target hot spots of the microelectronic elements in the chip package.

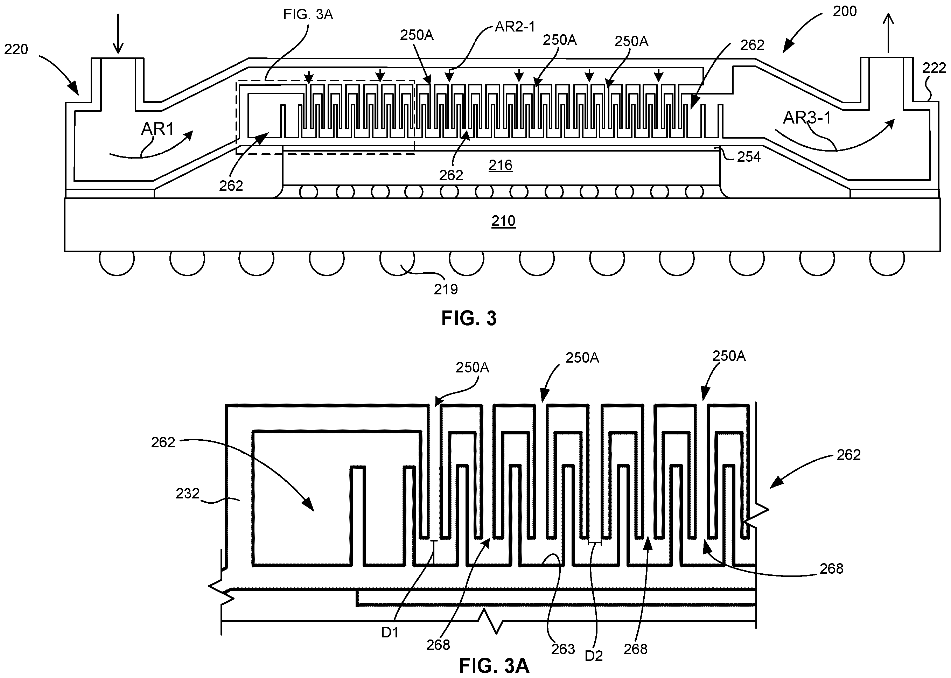

FIG. 3 illustrates another microelectronic package 200 according to an aspect of the disclosure. Package 200 includes the same structural features and characteristics of package 100 previously described and differs only to the extent that package 200 includes microjets or nozzles to provide greater control of fluid flow through apertures 250A. Similar features of package 200 will therefore not be described in detail for brevity and ease of discussion. Package 200 includes a package substrate 210, at least one microelectronic element 216 bonded to package substrate 210, and cooling system 220. Cooling system 220, which in this example includes cold plate lid 222, overlies package substrate 210 and at least one microelectronic element 216. Cooling system 220 may be bonded directly to package substrate 210 and thermally joined to the at least one microelectronic element 216 using a thermal interface material 254. As in the previous discussion, the at least one microelectronic element 216 will be referred to herein as microelectronic element 216, but the at least one microelectronic element 216 may be one microelectronic element or a plurality of microelectronic elements.

Cooling system 220 can provide enhanced cooling of microelectronic element 216 by controlling the flow of fluid within cooling system 220. For example, the direction of fluid flow to apertures 250A in intermediate flow plate 232 can be controlled, as well as the speed, amount, and direction of fluid flow to a surface of the cooling system 220 directly overlying the at least one microelectronic element 216. Thermal resistance may also be reduced due to the structure of cold plate lid 222 and the presence of only one thermal interface connection between cooling system 220 and microelectronic element 216. Terminals, such as solder balls 219, may be disposed at package substrate 210 and allow for interconnection of the package 200, including microelectronic element 216 and cooling system 220, to another device, such as a printed circuit board or the like.

Microjets or nozzles can provide directed streams of fluid, such as fluid coolant, that impinge upon and direct contact the surface of the cold plate lid that overlies semiconductor chips and/or high heat generating areas of the chip package. For example, microjets or nozzles 268 may be provided at or adjacent one, some, or all apertures 250A in intermediate flow plate 232 and face toward bottom surface 263 of heat exchange chamber 262. In some examples, nozzles 268 can help to control the speed and/or the amount of fluid flow through apertures 250A into heat exchange chamber 262For example, in the enlarged view of FIG. 3A, nozzles 268 may be spaced a pre-determined distance D1 from bottom surface 263 of heat exchange chamber 262 of cold plate lid 222. This can help to enhance cooling as nozzles can be brought very close to bottom surface 263 of heat exchange chamber 262 of cold plate lid 222, which can help to ensure that fluid flow is in a direction perpendicular to bottom surface 263 of heat exchange chamber 262 of cold plate lid 222, such that fluid flow impinges on the heated bottom surface 263 of heat exchange chamber 262. Further, microjets or nozzles 268 can cause fluid to flow at substantially higher speeds as compared to the rest of the flow speed of fluid within cold plate lid 222. Thus, heat that is thermally transferred from microelectronic element 216 into heat exchange chamber 262 can be more effectively cooled by fluid in heat exchange chamber 262 of cold plate lid 222.

Nozzles allow for spot cooling or targeting hot spots of the microelectronic elements, chips, or other components in the chip package. For example, nozzles 268 can be adjusted so that a perpendicular speed of fluid exiting nozzles 268 may be up to or more than 20 times that of the inlet speed value. In other examples, the perpendicular speed value may be up to or more than 20 times the inlet fluid speed value. In still other examples, the perpendicular speed value is more than 50 times that of the inlet fluid speed value. In still other examples, the perpendicular speed value may be less than 20 times the inlet fluid speed value or more than 20 times the inlet fluid speed value.

Nozzles 268 may be configured so that each nozzle can be adjusted to allow for more or less fluid through nozzle 268. For example, the diameters of each nozzle may be adjustable or preset to increase or decrease the amount of fluid flowing through each nozzle. In some examples, nozzle diameter D2 may be between 0.1 mm and 0.5 mm. In other examples, nozzle diameter D2 may be between 0.5 mm and 2.5 mm. In other examples, nozzle diameter D2 may be between 0.1 mm and 0.5 mm. In still other examples, nozzle diameter D2 may be between 0.1 mm and 2.5 mm. In still other examples, nozzle diameter D2 may be less than 0.1 mm or greater than 2.5 mm.

Fluid through heat exchange chamber 262 will otherwise move in the same direction through the inflow chamber 260, outflow chamber 264, and heat exchange chamber 262 as in the previous examples, and as shown by arrows AR1-1, AR1-2, and AR1-3, except that the optional use of nozzles can increase control over cooling and fluid flow to increase the amount of cooling that takes place in heat exchange chamber 262 and the overall cold plate lid 222.

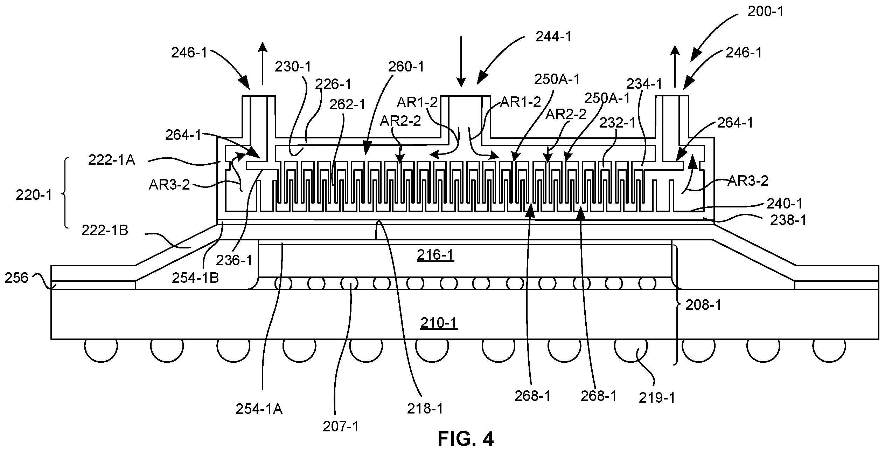

FIG. 4 illustrates another example chip package 200-1 that includes a cooling system 220-1 bonded to chip subassembly 208-1. Chip subassembly 208-1 may include package substrate 210-1, microelectronic element 216-1, solder balls 207-1 bonded to package substrate 210-1, and terminals 219-1 that are bonded to bottom surface 314 of package substrate 210-1. This chip package 200-1 differs from prior examples to the extent that cooling system 220-1 is comprised of two components: cold plate lid 222-1A and a secondary base plate 222-1B. As shown, secondary base plate 222-1B may be directly or indirectly bonded to package substrate 210-1 and thermally connected to microelectronic element 216-1 by a first thermal interface material 254-1A. In one example, cold plate lid 222-1A may be thermally attached to secondary base plate 222-1B with a second thermal interface material 254-1B. Additionally, secondary base plate 222-1B may be bonded to package substrate 210-1 with bonding material 256, which may be an adhesive.

As in the prior examples, cold plate lid 222-1A may include a top plate 226-1, an intermediate flow plate 232-1, and a first base plate 238-1. Inflow chamber 260-1 may be formed between bottom surface 230-1 of top plate 226-1 and top surface 234-1 of intermediate flow plate 232-1. A heat exchange chamber 262-1 may be formed between bottom surface 236-1 of intermediate flow plate 232-1 and top surface 240-1 of base plate 238-1.

Central inlet 244-1 may feed cooling fluid into inflow chamber 260-1 in the direction of arrows AR1-2. As in the previous examples, cooling fluid will fill inflow chamber 260-1. As fluid inflow chamber 260-1 directly overlies heat exchange chamber 262-1, fluid will flow through apertures 250A-1 and nozzles 268-1 in intermediate flow plate 232-1 in a direction of arrows AR2-2. In this example, fluid flows through apertures and nozzles 268-1 in a direction perpendicular or substantially perpendicular to rear surface 218-1 of microelectronic element 216-1. Heat may be transferred from microelectronic element 216-1 through first TIM 254-1A and second TIM 254-1B into cold plate lid 222-1. Heat will be transferred to cooling fluid in heat exchange chamber 262-1 and then flow to outflow chamber 264-1 in the direction of arrow AR3-2, where heated fluid will exit cold plate lid 222-1 through outlets 246-1. In this example, fluid only flows across or over rear surface 218-1 of microelectronic element 216-1 and will not flow adjacent microelectronic element 216-1, as in previous examples.

When arranged together, the components of cooling system 220-1 collectively possesses substantially the same profile and shape as cooling plate 222 of chip package 200 of FIG. 3. The primary difference being that the example chip package 200 of FIG. 3 is configured to allow for fluid to flow directly adjacent edge surfaces of the microelectronic element, as well as over rear surfaces of the microelectronic element. Further, only a single thermal interface material is required to bond cooling system 220 to chip package 200 shown in FIG. 3.

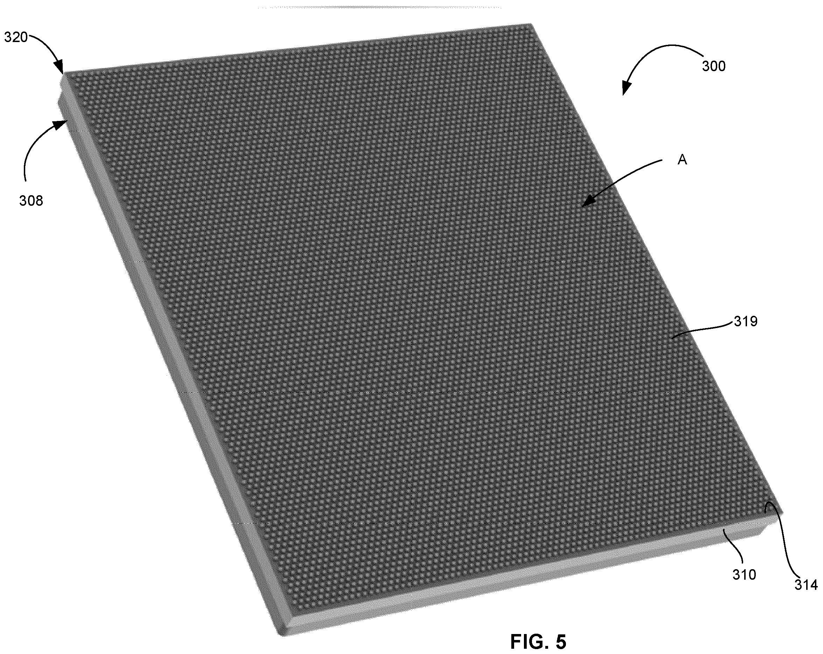

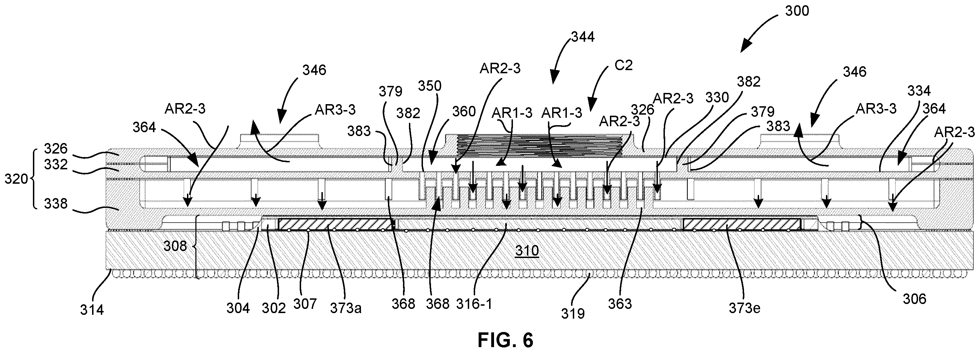

FIG. 5 illustrates a bottom perspective view of an example chip package 300 and FIG. 6 illustrates a schematic cross-sectional view of chip package 300. Chip package 300 may be a high power and high compute package with multiple chips, which can include processors, an AI accelerator, IP chip, memory chip, and the like, all of which may individually and collectively generate significant heat that can impact the integrity of the chip package 300. As in the previous examples, chip package 300 includes a chip subassembly 308 and cooling system 320 bonded to chip subassembly 308, and particularly bonded to package substrate 310 of chip subassembly 308. As shown, chip subassembly 308 may include package substrate 310, microelectronic element 316,373a, 373e, solder balls 307 that bond wafer 306 to package substrate 310, and terminals 319, which in this example may be solder balls, but in other examples fewer or additional components can be implemented with chip subassembly 308. As shown, an array A of solder balls 319 is bonded to bottom surface 314 of package substrate 310. With reference to FIG. 6, prior to incorporating chip subassembly 308 into chip package 300, reconstituted wafer 306 may be formed, wherein microelectronic elements 316-1, 373a, and 373e (along with other microelectronic elements not seen in this view) and overmold 302 applied in the gaps between all of the microelectronic elements in chip package 300 and around at least some surfaces of the microelectronic elements. Non-limiting examples of overmold may include polyetherimide ultem, FEP & PFA fluoropolymers, polyetheretherketone, neoflon, polyflon, epoxy, and silicone. Chip subassembly 308 may be bonded to package substrate 310 with solder balls 307. An underfill 304 may be used in the space between solder balls 307.

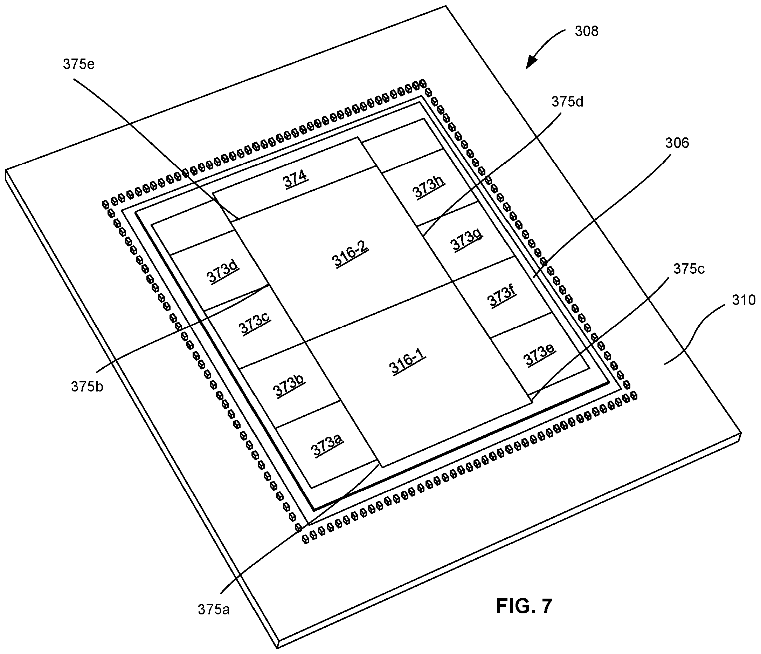

FIG. 7 illustrates an example chip subassembly 308 of chip package 300 that is shown standing alone and removed from package assembly 300 for ease of discussion. Chip subassembly 308 may include a package substrate 310 that supports a plurality of microelectronic elements coupled directly or indirectly to package substrate 310. Package substrate 310 can provide an electrical interconnection between the chips in the chip subassembly 308 and different circuits of a main board or printed circuit board to which the chip subassembly 308 and the overall chip package assembly will be attached. The package substrate 310 can provide protection and support for chips in the package subassembly 308. In some examples, package substrate 310 may be a rigid or semi-rigid substrate comprised of organic materials, ceramic materials, or other desired materials. In this example, without limitation, one or more chips may be a processing unit. For example, as will be discussed in more detail below, integrated circuit chips may be a central processing unit (CPU), graphics processing unit (GPU), field programmable gate arrays (FPGA), or application-specific integrated circuits (ASIC), such as a tensor processing unit (TPU). In some examples, the integrated circuit chips 316-1, 316-2 may be configured for efficient execution of certain types of operations, e.g., operations for accelerating machine learning model inference or training. Example operations include matrix-matrix multiplication, matrix-vector multiplication, quantization, and/or other operations for processing a machine learning model, such as a neural network.

In the arrangement of chip subassembly 308, reconstituted wafer 306 may be bonded to package substrate 310. Reconstituted wafer 306 may include two central chips that overlie package substrate 310 and a central portion of the chip arrangement. For example, arranged across a central portion may be a first chip 316-1 and a second chip 316-2, which, in this example, may be a first ASIC chip and a second ASIC chip. Memory chips 373a-373d may be positioned adjacent first and second ASIC chips 316-1, 316-2. As shown in this example, four memory chips 373a-373d are aligned on one side of respective lateral edges 375a, 375b of first and second ASIC chips 316-1, 316-2 and four memory chips 373e-373h are aligned along respective opposed lateral edges 375c, 375d of first and second ASIC chips 316-1, 316-2. A serializer/deserializer chip 374 may be adjacent an edge 375e that extends between lateral edges 375b and 375d of second ASIC chip 316-2. This example chip subassembly 308 illustrates one example arrangement of chips, but any types of chips and any arrangement of chips may be incorporated into reconstituted wafer 306 and chip subassembly 308. Further, chips may also be stacked within chip subassembly 308.

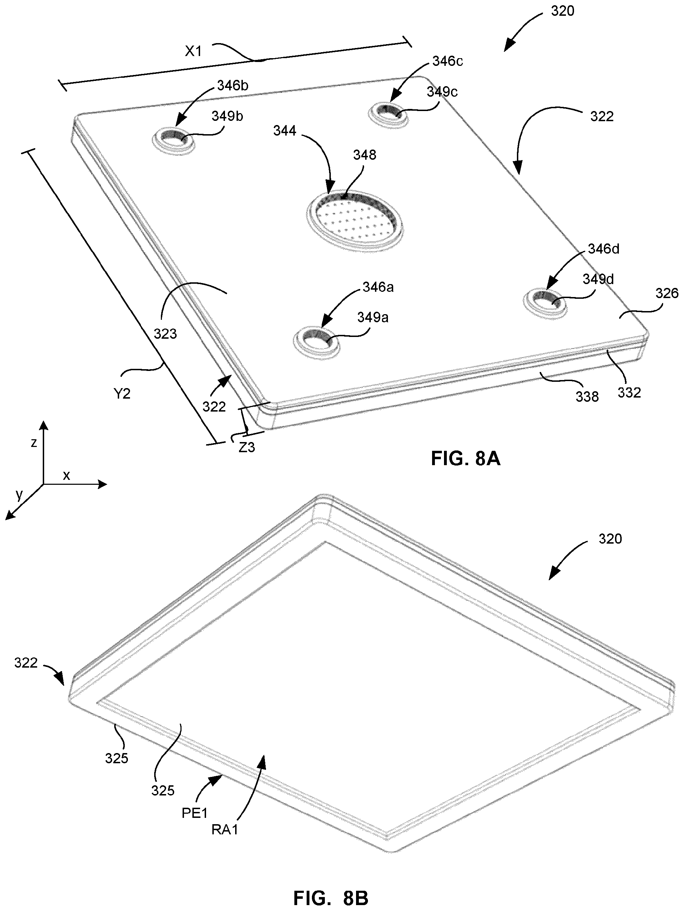

FIGS. 8A-8B illustrate views of cooling system 320, which in this example is also cold plate lid 322. In this example, cold plate lid 322 is a combination of a base plate 338, intermediate plate 332, and top plate 326. A central inlet 344 with a central opening 348 may be positioned in a middle of cold plate lid 322. Cooling fluid may enter cold plate lid 322 through central opening 348. Peripheral outlets 346a, 346b, 346c, 346d extend around central inlet 344 and includes openings 349a, 349b, 349c, 349d through which fluid from within interior 324 of cold plate lid 322 may exit cold plate lid 322.

Cold plate lid 322 is configured to have a streamlined profile and shape to minimize the overall size of chip package 300. The overall shape of cold plate lid 322 may be sized to match a shape of the package substrate 310. In this example, as shown in FIGS. 8A and 8B, cold plate lid 322 is in a shape of a square. Cold plate lid 322 may have major surfaces that are planar. As shown, top surface 323 of cold plate lid 322 may be substantially planar. Bottom surface 325 of cold plate lid 322 extends from a peripheral edge PE1 of cold plate lid 322 into a recessed area RA1. When assembled together with chip subassembly 308, cold plate lid 322 will directly overlie and be bonded to at least one of the microelectronic elements in chip subassembly 308.

As shown, the cold plate lid extends horizontally across the rear surface of the at least one semiconductor chip along an x-y plane and extends in a direction perpendicular to the rear surface of the at least one semiconductor chip along a z plane. In order to ensure a streamlined profile, the cold plate is generally planar and has a thickness that is significantly less than the length and width of the cold plate lid. For example, an x-y-z axis is illustrated in FIG. 8A. Cold plate lid has a length or first dimension X1 extending along an x direction of the x-y plane, a width or second dimension Y2 extending along a y direction of the x-y plane, and a thickness or third dimension Z3 extending along the z plane. In some examples, the first dimension and the second dimension will be greater than the third dimension. For example, the first dimension and the second dimension are each two or more times greater than the third dimension. In some examples, the first and second dimensions are ten or more times greater than the third dimension. In some examples, the first and second dimensions are at least five or more times greater than the third dimension. In other examples, the first and second dimension are two, three or four more times greater than the third dimension. Additionally, the first and second dimensions may be the same or different.

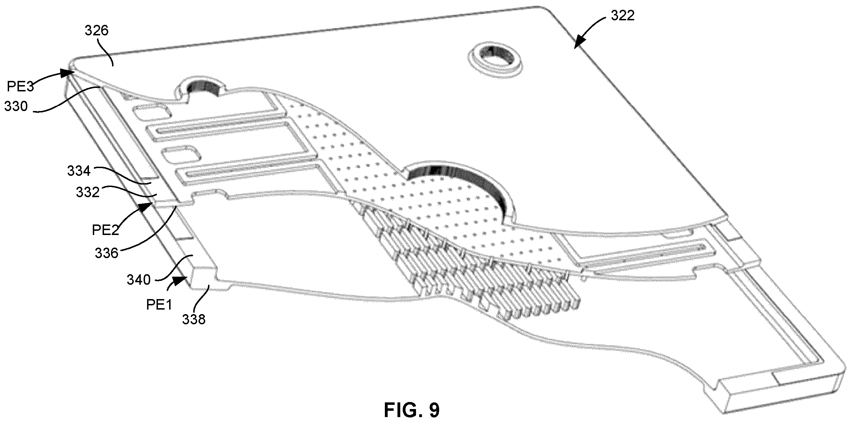

As better seen in FIG. 9, base plate 338, intermediate plate 332, and top plate 326 are discrete plates bonded together at their respective peripheral edges PE1, PE2, and PE3. For example, top surface 340 of base plate 338 is bonded to bottom surface 336 of intermediate plate 332; top surface 334 of intermediate plate 332 is bonded to bottom surface 330 of top plate 326. A bonding material, such as an adhesive, can be utilized to bond base plate 338, intermediate plate 332, and top plate 326 together. In other examples, where two or more of the plates are comprised of metal material(s), plates may be welded together. In other examples, two or more of the three components may be integrally formed. Base plate 338, intermediate plate 332, and top plate 326 will each be discussed in more detail below.

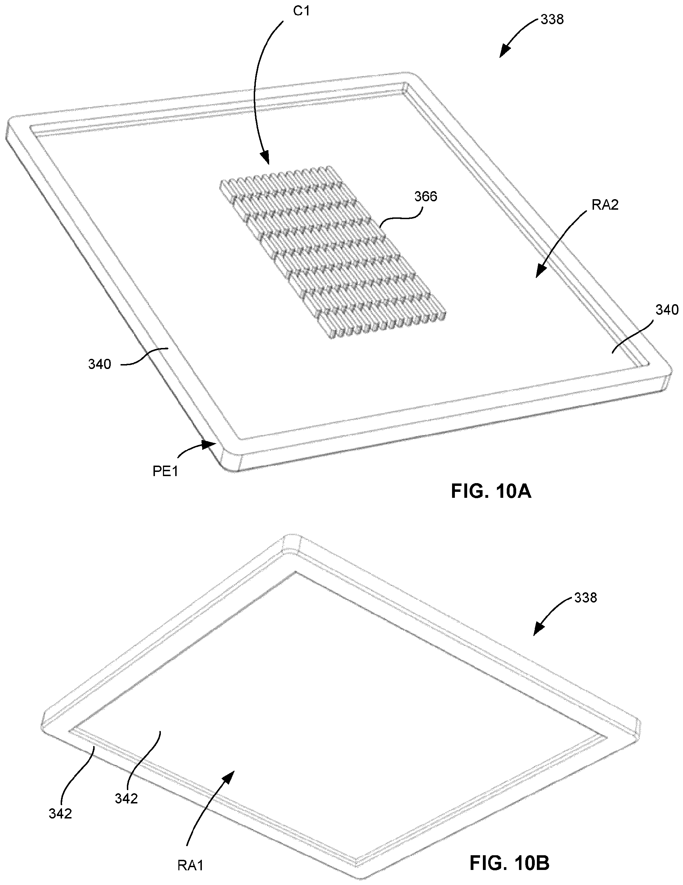

FIGS. 10A-10B illustrate top and bottom perspective views of base plate 338. As shown, base plate 338 includes a top surface 340 that extends from a peripheral edge PE1 into a recessed area RA2. Recessed area RA2 includes a plurality of cooling elements 366 that extend upwards from top surface 340 of base plate 338. Cooling elements 366 can be any element intended to help cool down and/or dissipate heat emanating from microelectronic elements that will be in close proximity to base plate 338. For example, fins or microchannels are non-exhaustive examples of cooling elements. In this example, cooling elements 366 are positioned along a central portion C1 of recessed area RA2 of base plate 338 so that they overlie high power chips that generate a significant amount of heat, which in this example are processing microelectronic elements 316-1 and 316-2. Bottom surface 342 of base plate 338 is also the same bottom surface 342 of cooling lid plate 322 and includes the same features of cooling plate 322 previously described herein, including recessed area RA1.

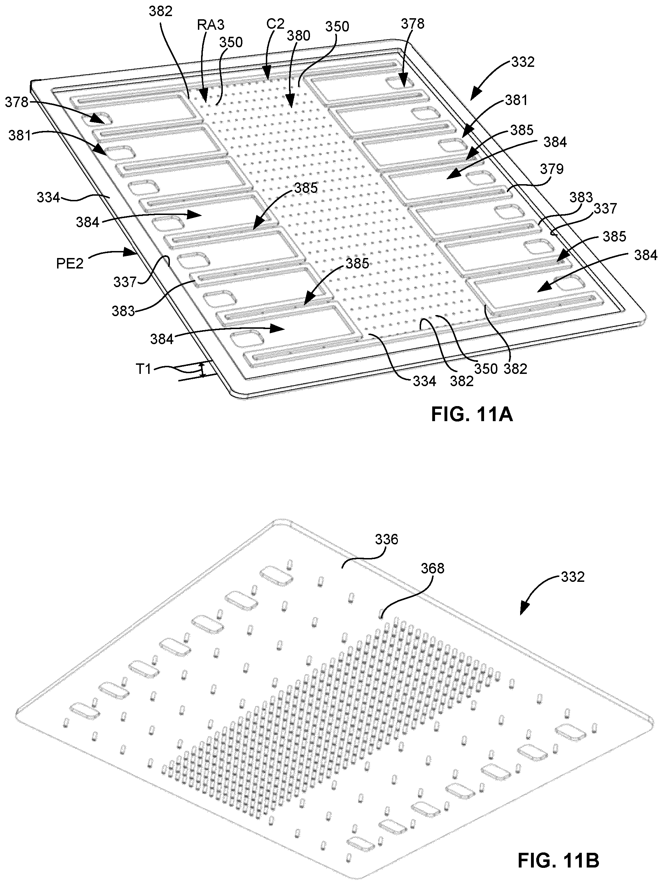

FIGS. 11A-11B are respective top and bottom perspective views of an example intermediate flow plate 332. As shown, intermediate flow plate 332 includes a top surface 334 that extends from its outer peripheral edge PE2 into a recessed area RA3. An interior peripheral edge 337 extends around the periphery of recessed area RA3. A plurality of inflow apertures 350 extend along a central portion C2 of intermediate flow plate 332 and outflow apertures 378 extend adjacent interior peripheral edge 337. Flow wall 379 extends within recessed area RA3 and upwardly from top surface 334 of recessed area RA3. In this example, flow wall 379 is configured to separate intermediate flow plate 332 into different regions. In this example, flow wall 379 can separate intermediate flow plate 332 into at least two regions: inflow region 380 and outflow region 381. Interior edge 382 of flow wall 379 extends circumferentially around and defines inflow region 380. Outflow region 381 is defined by exterior edge 383 of flow wall 379 and interior peripheral edge 337 of intermediate flow plate 332. All inflow apertures 350 are positioned within inflow region 380 and all outflow apertures 378 are positioned within outflow region 381.

Flow wall 379 may be configured to separate inflow and outflow regions into smaller sections. For example, flow wall 379 may be a continuous wall configured to create a plurality of rectangular outflow sections 384. Each rectangular outflow section 384 may be spaced apart from one another so as to create a plurality of elongated inflow sections 385 in the space between each rectangular outflow section 384. At least one outflow aperture 378 may be positioned within each rectangular outflow region 384. Inflow apertures 350 may extend into each elongated inflow section 385 and be positioned between each rectangular outflow region 384, such that apertures 350 extend across a substantial portion of intermediate flow plate 332. Inflow apertures 350 and outflow apertures 378 extend through top surface 334 of recessed area RA3 and bottom surface 336 of intermediate flow plate 332. As in the previous examples, there may be any number, shape, size, or profile of inflow apertures 350 and outflow apertures 378.

A plurality of nozzles 368 may optionally be provided at bottom surface 336 of intermediate flow plate 332, as shown in FIG. 11B. Each nozzle 368 may extend a pre-determined distance away from bottom surface 332 of intermediate flow plate 336. As in the previous examples, nozzles 368 may include any shape, size, or profile. Each inflow aperture 350 may provide an opening to nozzles 368 so as to feed cooling fluid into nozzles 368.

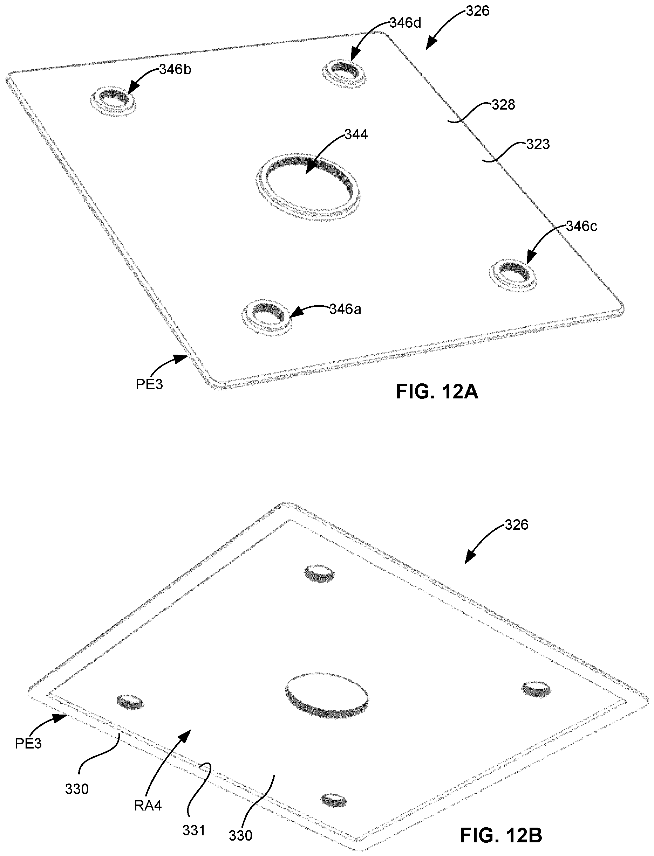

FIGS. 12A-12B illustrate the respective top surface 328 and bottom surface 330 of top plate 326. Top surface 328 is also top surface 323 of the overall cold plate lid 322 and includes the same features. Central inlet 344 and peripheral outlets 346a, 346b, 346c, 346d extend through top surface 323 and bottom surface 330 of cold plate lid 322. As shown, bottom surface 330 extends from peripheral edge PE3 into recessed area RA4. Bottom surface 330 may include a recessed area RA4 that is substantially planar. An inner peripheral edge 331 extends around recessed area RA4.

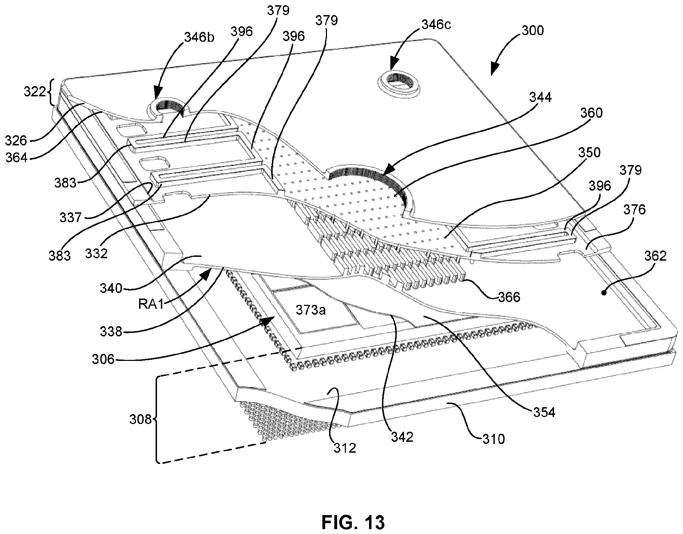

FIG. 13 depicts a cross-sectional cutaway view of chip package 300, in which cooling system 320 is attached to chip subassembly 308. Cold plate lid 322 may be bonded directly to package substrate 310. As shown, at least a portion of bottom surface 342 of base plate 338 that is adjacent peripheral edge PE1 will be bonded to top surface 312 of package substrate 310. Reconstituted wafer 306 includes each of the previously identified chips in chip subassembly 308 (FIG. 7), and may be positioned within recessed area RA1 of base plate 338. Bottom surface 342 of base plate 338 is shown bonded to one or more chips 316-1, 316-2, 373a-h, and 374 in chip subassembly 308. In some examples, there may be an overmold or other intermediate material between the one or more chips 316-1, 316-2, 373a-h, and 374 and cold plate lid 322, but it is to be understood that discussion of base plate 338 being bonded or attached to one or more chips 316-1, 316-2, 373a-h, and 374, includes being bonded or attached to the one or more chips 316-1, 316-2, 373a-h, and 374 through an intermediate material, such as, but not limited to an overmold.

Intermediate flow plate 332 is shown positioned between top plate 326 and base plate 338 and separates the interior of cold plate lid 320 into different chambers. Inflow chamber 360 is formed between top surface 350 of intermediate flow plate 332, bottom surface 330 of top plate, and interior edge surface 382 of flow wall 379. Outflow chamber 364 is defined in the space between bottom surface 330 of top plate 326, top surface 334 of flow plate 332, and outer edge surface 383 of flow wall 379. Nozzles 368 are shown extending toward cooling elements 366 and top surface 340 of base plate 338 and will provide control over fluid entering heat exchange chamber.

Top plate 326 overlies intermediate flow plate 332. An inflow region is defined in the space between bottom surface 330 of top plate 326 and top surface 334 of intermediate flow plate 332, as well as along interior edge surface 382 of flow wall 379. An outflow region is defined in the space between bottom surface 330 of top plate 326 and top surface 334 of intermediate flow plate 332, as well as outer edge surface 383 of flow wall 379 and inner peripheral edge 337.

With reference to FIGS. 6 and 13, in use, cooling fluid will enter central inlet 344 and fill inflow chamber 360. Incoming fluid may flow in the direction of arrow AR1-3. Flow wall 379 will help to be maintain fluid within a central portion of inflow chamber 360 that overlies inflow apertures 350. Top surface 396 of flow wall 379 may contact bottom surface 330 of top plate 326 to form an enclosed inflow chamber 360. Inflowing fluid will be maintained within inflow chamber 360 and bound by interior edge surface 382 of flow wall 379, bottom surface 330 of top plate 326, and top surface 334 of flow plate 332. Fluid within inflow chamber 360 will enter into apertures 350 that lead to nozzles 368. Fluid will be dispersed into heat exchange chamber 362 in a direction perpendicular to bottom surface 363 of heat exchange chamber 362, which is also top surface 340 of bottom plate 338. For example, fluid will flow in the direction of arrow AR2-3. Fluid that is now heated due to the transfer of heat from chips in package subassembly 308 through thermal interface material 354 will be dispersed into outflow chamber 364 in the direction of arrow AR3-3 and eventually exit cold plate lid 322 through one of the outlets 346a, 346b, 346c, 346d.

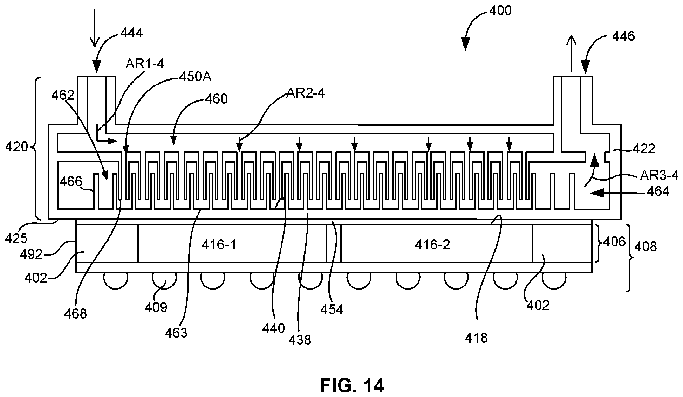

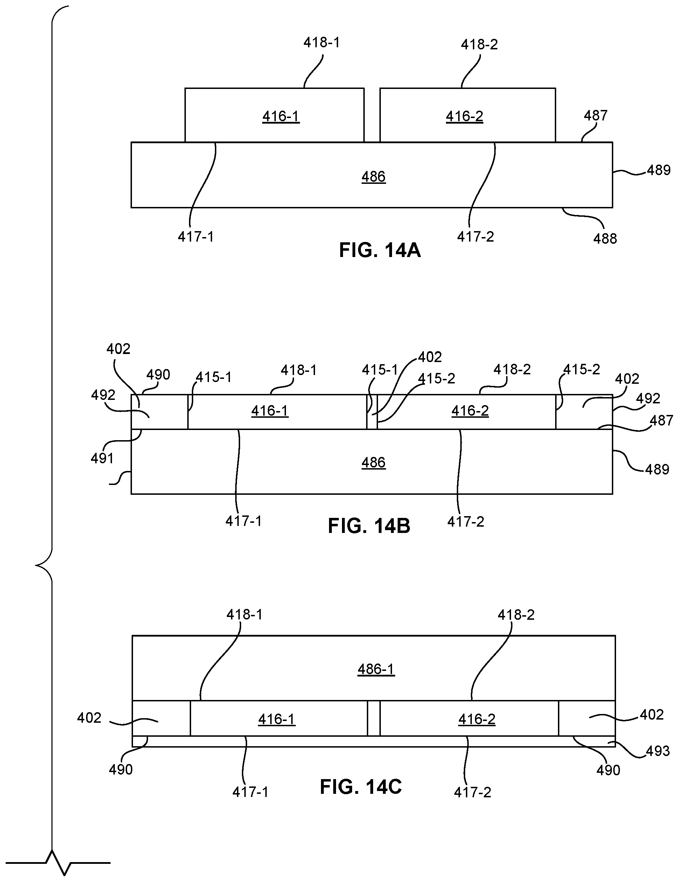

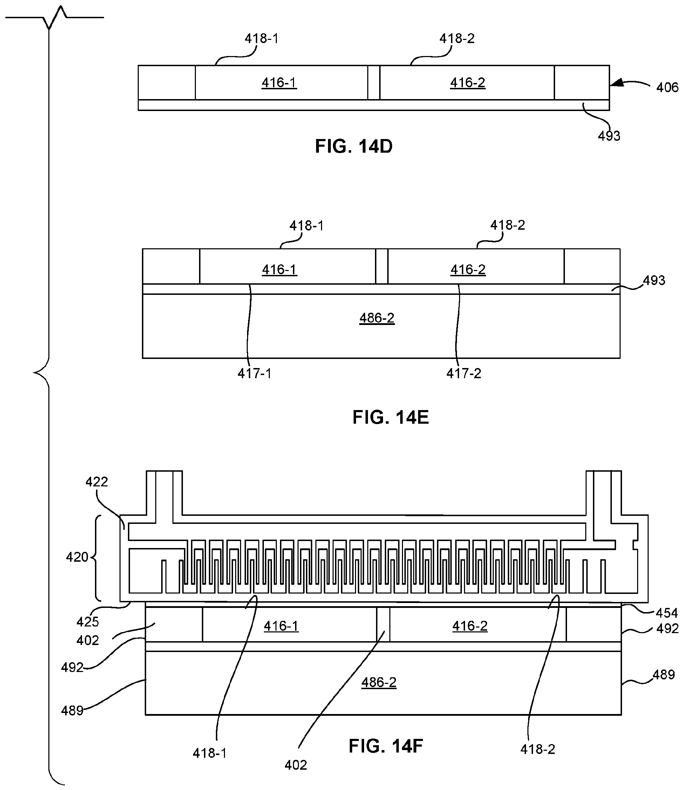

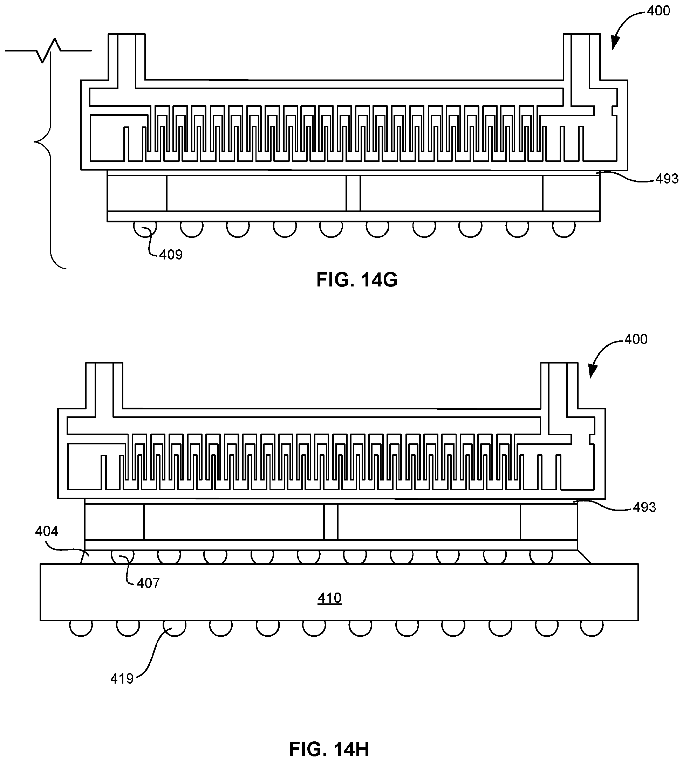

FIG. 14 illustrates another example chip package 400, which is manufactured with wafer or panel level reconstituted packaging followed by bonding of the cooling system. This method can allow for a cold plate lid designed according to aspects of the disclosure to be integrated into an overall chip package 400. As shown, chip package 400 differs to the extent that chip package 400 is not shown further bonded to a substrate or a main board. Chip package 400 may otherwise include similar components as previously discussed herein, which will be briefly described for brevity and ease of discussion and to further aid in the discussion of a method for manufacturing chip package 400 discussed in FIGS. 14A-14G. Package 400 includes a chip subassembly 408 and a cooling system 420, such as cold plate lid 422, bonded to chip subassembly 408. Chip subassembly 408 includes a reconstituted wafer 406 with chips 416-1 and 416-2 and overmold 402 surrounding edges of chips 416-1, 416-2. Cold plate lid 422 includes an inlet 444 for entry of cooling fluid into cold plate lid 422 and an outlet 446 through which heated liquid will exit cold plate lid 422. Bottom surface 425 of cooling system 420 may be bonded to wafer 406 with a thermal interface material 454 with high thermal conductivity and in this example, extends beyond edges 492 of overmold 402.

As in previous examples, when cold plate lid 122 is in use, fluid entering cold plate lid 422 will flow into and fill inflow chamber 460 in the direction shown by arrow AR1-4; flow through apertures 450A and nozzles 468 in a direction of arrow AR2-4; flow through heat exchange chamber 462 where heat emanating from chips 416-1 and 416-2 (and any other chips or components in chip package 400 not shown) will be cooled down and dissipated; and flow through outflow chamber 464 in a direction of arrow AR3-4, where heated liquid will flow through and exit cold plate lid 422 through outlet 446.

In this example, inflow chamber 460 directly overlies heat exchange chamber 462, which houses cooling elements 466. Fluid will flow through apertures 450A and nozzles 468 toward bottom surface 463 of heat exchange chamber 462. Due to the configuration of cold plate lid 422, fluid will flow through apertures 450A in a direction perpendicular to bottom surface 463 of heat exchange chamber 462 and rear surface 418 of chips 416-1, 416-2, other chips in wafer 406, and top surface 440 of base plate 438. Further, as in the previous examples, nozzles 468 can be optionally included to provide increased control over the speed of the fluid flow and the direction of the fluid flow.

FIGS. 14A-14G illustrate a method of manufacturing chip package 400 in which the example cooling system 420, which in this example cold plate lid 422, is integrated and bonded as part of chip package 400 toward the end of the manufacturing process. In other examples, other types of cooling systems, including the cold plate lids disclosed herein or variations thereof, may be manufactured according to the same or similar procedures as outlined below.

As shown in FIG. 14A, one or more microelectronic element, such as semiconductor chips 416-1 and 416-2 may be attached to a carrier 486, such as a wafer or panel. In this example, active faces 417-1, 417-2 of respective chips 416-1, 416-2 may be attached to top surface 487 of carrier 486. Carrier 486 may further include a bottom surface 488 and an edge surface 489 that extends between the top and bottom surfaces 487, 488. The semiconductor chips can be any chips, as previously described herein.

FIG. 14B illustrates the process of polishing chips 416-1, 416-2 to a desired thickness. Overmold 402 may be deposited onto exposed top surface 487 of carrier 486, around edges 415-1, 415-2 of respective chips 416-1,416-2 and in the spaces between edges 415-1 of chip 416-1 and edge 415-2 of adjacent chip 416-2. In this example, rear surfaces 418-1, 418-2 remain exposed. Overmold 402 may have an exposed surface 490 and interior surface 491 and may be configured so that outermost edges 492 of overmold 402 are aligned with edge surfaces 489 of carrier 486. Overmold 402 can be comprised of desired materials, including those previously described herein.

FIG. 14C illustrates removal of carrier 486 and repositioning another carrier 486-1 on passive or rear surfaces 418-1, 418-2 of chips 416-1, 416-2. As shown, carrier 486-1 is positioned so that carrier 486-1 overlies passive or rear surfaces 418-1, 418-2 of chips 416-1, 416-2 and so that active surfaces 417-1, 417-2 are exposed. Circuitry 493 may be provided onto active surfaces 417-1, 417-2 of respective chips 416-1, 416-2, as well as along exposed surface 490 of overmold 402. In some examples, circuitry 493 can include multiple layers of circuitry that will provide for an electrical interconnection. For example, circuitry 493 may include redistribution layers or other features to provide an interconnection between chips 416-1, 416-2 and other components in the same package or another package to which chips 415-1, 416-2 are connected.

FIG. 14D illustrates removal of carrier 486 and exposure of rear surfaces 418-1, 418-2 of respective chips 416-1, 416-2, such that reconstituted wafer 406 with circuitry 493 remains. FIG. 14E shows providing another carrier 486-2 that underlies circuitry 493. Active surfaces 417-1, 417-2 of respective chips 416-1, 416-2 face toward carrier 486-2 and rear surfaces 418-1, 418-2 face away from carrier 486.

FIG. 14F illustrates the addition and integration of cooling system 420 into chip package 400. As described with regard to FIG. 14, cooling system 420, in this example cold plate lid 422, may be directly attached to respective chips 416-1, 416-2. In this example, bottom surface 425 of cold plate lid 422 may be directly attached to rear surfaces 418-1, 418-2 of respective chips 416-1, 416-2 using a high thermally conductive interface material 454 that is deposited between cold plate lid 422 and respective chips 416-1, 416-2. Bottom surface 425 of cold plate lid 422 may extend beyond edge surfaces 492 of overmold 402 and edge surfaces 489 of carrier 486. A portion of cold plate lid 422 may also be attached to overmold 402, which can further function as a support for cold plate lid 422.

Carrier 486-2 may be removed and, as shown in FIG. 14G, terminals 407 may be provided to form a completed chip package 400 (also FIG. 14). In this example, terminals 407 may be solder balls that are bonded to circuitry 493 and arranged in an array across chip package 400, but other types of terminals may be utilized. For example, bond pads or posts or other conductive components may be used to electrically interconnect chip package 400 with another external component. As shown in FIG. 14H, chip package 400 can optionally be further attached to a package substrate, external device, a main board or the like. As shown, chip package 400 may be bonded to substrate 410 using terminals 407 to form a connection between substrate 410 and package 400. Underfill 404 may fill the space between terminals 409. Further terminals 419 may be provided at a surface of substrate 410.

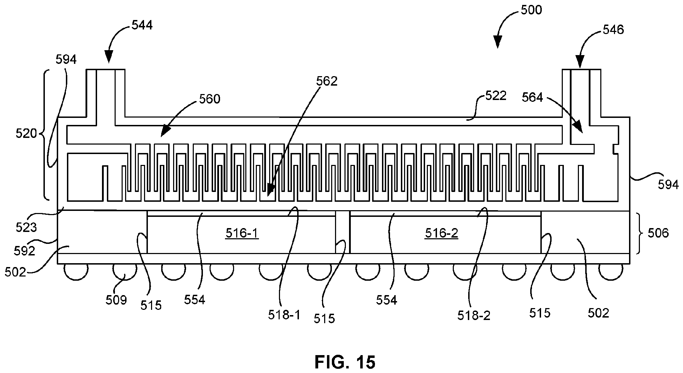

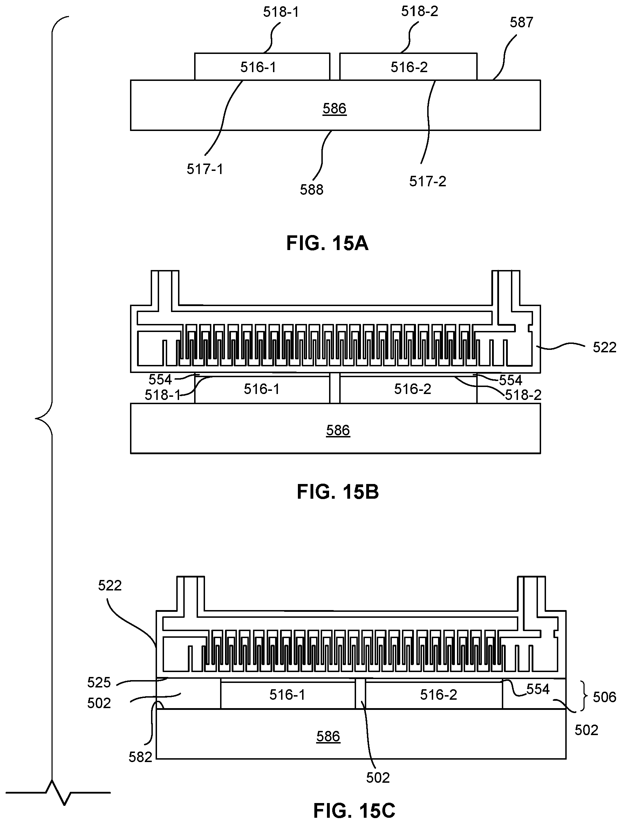

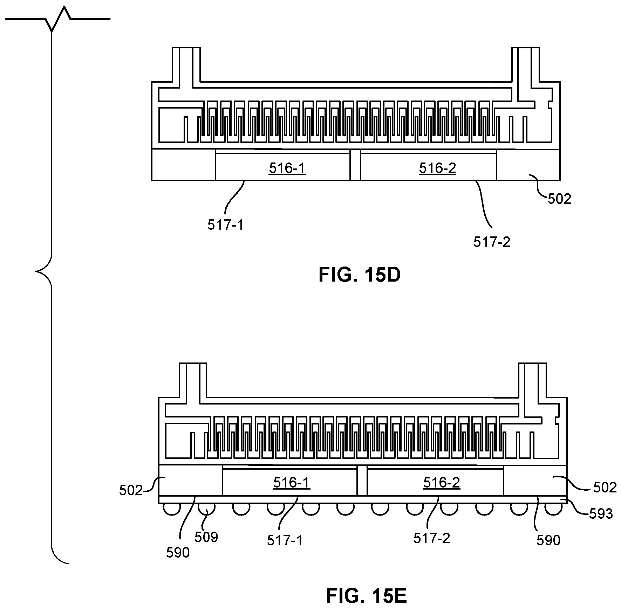

FIG. 15 is another example chip package 500. Chip package 500 is structurally similar to chip package 400, except that bottom surface 523 and edge 594 of cold plate lid 522 do not extend past or beyond edge 592 of overmold 502 of reconstituted wafer 506. Additionally, as will be discussed with regard to FIGS. 15A-15E, the method of manufacturing differs from the example of FIGS. 14A-14G. As in the previous examples, package 500 otherwise includes cold plate lid 522 with inlet 544, outlet 546, inflow chamber 560, heat exchange chamber 562, and outflow chamber 564. As shown, reconstituted wafer 506 includes chips 516-1, 516-2, with overmold 502 extending around edges 515 of chips 516-1, 516-2 Cooling system 520 may be bonded to wafer 506 using TIM 554, which in this example will only extend across rear surfaces 518-1, 518-2 of respective c hips 516-1, 516-2.

FIGS. 15A-15D illustrate an example method of manufacturing chip package 500. Although the chip package 500 includes the example cooling system described with regard to FIG. 15, other cooling systems, including the cold plate lids disclosed herein or variations thereof, may be manufactured according to the same or similar procedures, as outlined below. Referring first to FIG. 15A, a carrier 586 is shown with a top surface 587 and bottom surface 588. Chips 516-1, 516-2 may be bonded to top surface 587 of carrier 586 in a face down configuration, such that active surfaces 517-1, 517-2 of respective chips 516-1, 516-2 face toward carrier 586 and rear surfaces 518-1, 518-2 face away from carrier 586.

As shown in FIG. 15B, cooling system 520, and particularly cold plate lid 522, can be bonded to rear surfaces 518-1, 518-2 of respective chips 516-1, 516-2. A thermal interface material 554 can be used to both bond cold plate lid 522 to chips 516-1, 516-2, as well as to thermally conduct heat emanating from chips 516-1, 516-2.

As shown in FIG. 15C, overmold 502 may be added. In one example, overmold 502 may be provided in the space between bottom surface 525 of cold plate lid 522 and top surface 582 of carrier 586. In this example, overmold 502 is added after cold plate lid 522 has been bonded to chips 516-1, 516-2.

As shown in FIG. 15D, carrier 586 is removed to expose active surfaces 517-1, 517-2 of respective chips 516-1, 516-2. Figure 15E depicts the addition of circuitry 593 to wafer 506, including exposed front surfaces 517-1, 517-2 of respective chips 516-1, 516-2, as well as exposed surface 590 of overmold 502. An array of terminals may be provided, such as solder balls 509. As in the example of FIGS. 14H, package 500 may optionally be further attached to another component, such as a substrate, circuit board, or other panel.

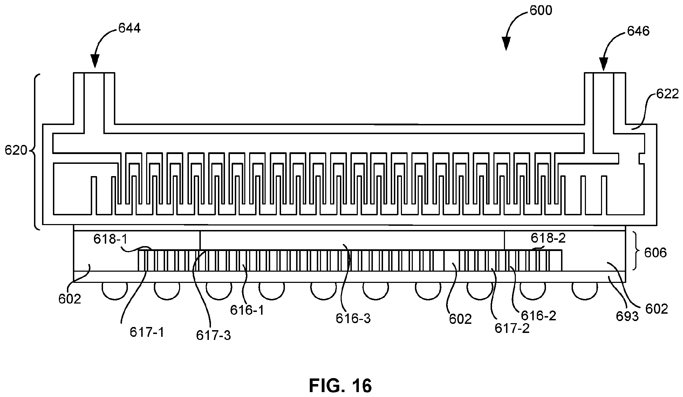

FIG. 16 illustrates another chip package 600. This example is similar to the prior examples and differs only to the extent that the reconstituted wafer includes stacked chips. For example, as shown, cooling system 620, which in this example is cold plate lid 622, includes an inlet 644 and outlet 646. overlies and is bonded to reconstituted wafer 606. Reconstituted wafer may include first chip 616-1, second chip 616-2, and third chip 616-3, which overlies first and second chips 616-1, 616-2. Overmold 602 may extend around edges of each of the chips, as well as between first and second c hips 616-1, 616-2. Frist chip 616-1 and second chip 616-2 may be positioned with active surfaces 617-1, 617-2 facing towards circuitry. Third chip 616-3 may have an active face 617-3 facing towards rear surfaces 618-1, 618-2 of first and second chips 616-1, 616-2. Third chip 616-3 may be electrically connected with circuitry 693 through silicon vias 695 that extend through front and rear surfaces 617-1, 618-1 of first chip 616-1, as well as through front and rear surfaces 617-2, 618-2 of second chip 616-2. Chip package may be attached to a package substrate or main board as previously discussed herein.

According to an aspect of the disclosure, a semiconductor chip package includes a package substrate, at least one semiconductor substrate, and a cold plate lid configured to cool the at least one semiconductor chip and minimize warpage of the package substrate. The package substrate may have terminals disposed at a surface. The cold plate lid may be bonded to the package substrate and thermally attached to the at least one semiconductor chip. The cold plate lid may further include an interior space; a fluid inlet; a fluid outlet in communication with the interior space; a base plate thermally attached to the at least one semiconductor chip; and a flow plate positioned within the interior space and overlying the base plate. The flow plate may have a plurality of inflow apertures that extend between top and bottom surfaces of the flow plate so that fluid flowing within the interior space may flow through the apertures and in a direction perpendicular to the base plate; and/or
the flow plate may further include an inflow region, an outflow region, and a flow wall separating the inflow and outflow region; and/or
the flow plate may further include a plurality of outflow apertures positioned within the outflow region and the inflow region may be located on a central portion of the flow plate and between the plurality of outflow apertures extending along an edge of the flow plate; and/or
the base plate and the flow plate may be integrally formed; and/or
the cold plate lid may be bonded to the at least one semiconductor chip using a thermal interface material; and/or
the cold plate lid may further include an inner edge that is laterally adjacent the substrate and extends around a periphery of the at least one semiconductor chip; and/or
the cold plate lid is sealed except for the fluid inlet and the fluid outlet; and/or
the semiconductor chip package further includes microjets positioned adjacent the inflow apertures that are configured to increase a perpendicular flow speed of fluid traveling through the microjets and direct a flow direction of the fluid within cold plate lid in a direction perpendicular to a front or rear surface of the at least one semiconductor chip, such that the perpendicular flow speed is greater than a flow speed through the fluid inlet of the cold plate lid; and/or
the perpendicular flow speed through the inflow apertures is more than five times that of an inlet flow speed of fluid flowing into the cold plate lid through the fluid inlet; and/or
the at least one semiconductor chip comprises at least one high compute integrated circuit chip and a memory chip positioned adjacent one another; and/or
the at least one semiconductor chip is a plurality of semiconductor chips, and wherein the chip package further comprises a reconstituted wafer comprised of the plurality of semiconductor chips embedded within an overmold.

According to another aspect of the disclosure, a system includes a printed circuit board and a semiconductor chip package, the semiconductor package include a package substrate having terminals disposed at a surface and bonded to the printed circuit board; at least one semiconductor chip; and a cold plate lid configured to cool the at least one semiconductor chip and minimize warpage of the package substrate. The cold plate lid may be bonded to the package substrate and thermally attached to the at least one semiconductor chip. The cold plate lid may further include an interior space; a fluid inlet and a fluid outlet in communication with the interior space; a base plate thermally attached to the at least one semiconductor chip; and a flow plate positioned within the interior space and overlying the base plate. The flow plate may have a plurality of inflow apertures that extend between top and bottom surfaces of the flow plate so that fluid flowing within the interior space may flow through the apertures and in a direction perpendicular to the base plate.

According to another aspect of the disclosure, a chip package includes a chip subassembly and a cooling system. The chip subassembly includes a package substrate; terminals disposed at a surface of the package substrate; and a reconstituted wafer. The reconstituted wafer may be bonded to the package substrate and further include a plurality of semiconductor chips embedded within an overmold. The cooling system may be bonded to the package substrate of the chip subassembly and thermally attached to a rear surface of at least one of the plurality of semiconductor chips. The cooling system may include a main body that includes a base plate, a top plate and an intermediate flow plate. The main body may have a major surface overlying the rear surface of the at least one of the plurality of semiconductor chips. The top plate may overlie the base plate. The intermediate flow plate may be positioned between the top and base plates. The intermediate flow plate may include a plurality of inflow apertures that extend between the top and bottom surfaces of the intermediate flow plate so that fluid flowing across intermediate flow plate may flow through the inflow apertures and in a direction perpendicular to the base plate; and/or
the base plate, the top plate, and the intermediate flow plate are discrete components attached to one another; and/or
the base plate, the top plate, and the intermediate flow plate are integrally formed as a single unit; and/or
the cooling system further comprises a first fluid chamber, a second heat exchange chamber, and cooling elements. The first fluid chamber may be formed in a space between the base plate and the intermediate flow plate and extend around a periphery of the reconstituted wafer. The second heat exchange chamber may be formed between the intermediate flow plate and the base plate for receiving fluid. The cooling elements may be positioned within the second heat exchange chamber to assist with dissipation of heat within the second heat exchange chamber; and/or

the cooling system may be bonded to at least some of the plurality of semiconductor chips with a thermal interface material.

According to another aspect of the disclosure, a method of manufacturing a chip package includes attaching first and second semiconductor chips to a carrier substrate; applying a thermal interface material to a bonding surface of the first and semiconductor chips; bonding a cold plate lid to the bonding surface of the first and second semiconductor chips; filling a space between exposed surfaces of the carrier substrate and a bottom surface of the cold plate lid and adjacent edges of the first and second semiconductor chips with an overmold; removing the carrier substrate; and providing terminals to the chip package; and/or
bonding the cold plate lid to the overmold; and/or
bonding the cold plate lid to a package substrate supporting the first and second semiconductor chips.

According to another aspect of the disclosure, a semiconductor chip package includes a package substrate, at least one semiconductor chip, and a cold plate lid. The package substrate includes terminals disposed at a surface. The at least one semiconductor chip has a front surface bonded to the package substrate and an opposed rear surface. The cold plate lid may be configured to cool the at least one semiconductor chip and minimize warpage of the package substrate. The cold plate lid may be bonded to the package substrate and thermally bonded to the rear surface of the at least one semiconductor chip. The cold plate lid further comprises an outer housing, a fluid inlet and a fluid outlet, and a flow plate. The outer housing may define an interior space and have a bottom surface bonded to the at least one semiconductor chip. The fluid inlet and the fluid outlet may be in communication with the interior space. The flow plate may be positioned within the interior space and divide the interior space into an upper chamber and a lower chamber. The flow plate may have a plurality of inflow apertures that extend between the top and bottom surfaces of the flow plate so that fluid flowing into the interior space flows from the upper chamber through the apertures and into the lower chamber in a direction perpendicular to the rear surface of the semiconductor chip; and/or
the flow plate further includes an inflow region, an outflow region, and a flow wall separating the inflow and outflow regions; and/or
the flow plate further includes a plurality of outflow apertures positioned within the outflow region, and the inflow region is located on a central portion of the flow plate and between the plurality of outflow apertures extending along an edge of the plate; and/or
microjets are positioned adjacent the inflow apertures. The microjets are configured to increase a perpendicular flow speed of fluid traveling through the microjets and direct a flow direction of the fluid within cold plate lid in a direction perpendicular to a front or rear surface of the at least one semiconductor chip, such that the perpendicular flow speed is greater than a flow speed through the fluid inlet of the cold plate lid; and/or
the perpendicular flow speed through the inflow apertures is more than five times that of an inlet flow speed of fluid flowing into the cold plate lid through the fluid inlet; and/or
the cold plate lid extends horizontally across the rear surface of the at least one semiconductor chip along an x-y plane and extends in a direction perpendicular to the rear surface of the at least one semiconductor chip along a z plane, wherein the cold plate lid has a first dimension extending along an x direction of the x-y plane, a second dimension extending along a y direction of the x-y plane, and a third dimension extending along the z plane, wherein the first dimension and the second dimension are each ten or more times greater than the third dimension; and/or
the cold plate lid further comprises an edge that is laterally adjacent the at least one semiconductor chip and extends around a periphery of the at least one semiconductor chip; and/or
the cold plate lid is thermally bonded to the at least one semiconductor chip using a thermal interface material; and/or
the at least one semiconductor chip comprises at least one high compute integrated circuit chip and a memory chip positioned adjacent one another; and/or
the at least one semiconductor chip is a plurality of semiconductor chips, and wherein the chip package further comprises a reconstituted wafer comprised of the plurality of semiconductor chips embedded within an overmold; and/or
the outer housing further comprises a top plate overlying a top surface of the flow plate and a base plate underlying the bottom surface of the flow plate, and wherein the base plate and the flow plate are integrally formed, and wherein the cold plate lid is sealed except for the fluid inlet and the fluid outlet.

According to another aspect of the disclosure, a system includes a printed circuit board and a semiconductor chip package with terminals are bonded to the printed circuit board. The semiconductor chip package includes a package substrate, at least one semiconductor chip, and a cold plate lid. The package substrate includes terminals disposed at a surface. The at least one semiconductor chip has a front surface bonded to the package substrate and an opposed rear surface. The cold plate lid may be configured to cool the at least one semiconductor chip and minimize warpage of the package substrate. The cold plate lid may be bonded to the package substrate and thermally bonded to the rear surface of the at least one semiconductor chip. The cold plate lid further comprises an outer housing, a fluid inlet and a fluid outlet, and a flow plate. The outer housing may define an interior space and have a bottom surface bonded to the at least one semiconductor chip. The fluid inlet and the fluid outlet may be in communication with the interior space. The flow plate may be positioned within the interior space and divide the interior space into an upper chamber and a lower chamber. The flow plate may have a plurality of inflow apertures that extend between the top and bottom surfaces of the flow plate so that fluid flowing into the interior space flows from the upper chamber through the apertures and into the lower chamber in a direction perpendicular to the rear surface of the semiconductor chip;
the flow plate further includes an inflow region, an outflow region, and a flow wall separating the inflow and outflow regions; and/or
the flow plate further includes a plurality of outflow apertures positioned within the outflow region, and the inflow region is located on a central portion of the flow plate and between the plurality of outflow apertures extending along an edge of the plate; and/or
microjets are positioned adjacent the inflow apertures. The microjets are configured to increase a perpendicular flow speed of fluid traveling through the microjets and direct a flow direction of the fluid within cold plate lid in a direction perpendicular to a front or rear surface of the at least one semiconductor chip, such that the perpendicular flow speed is greater than a flow speed through the fluid inlet of the cold plate lid; and/or
the perpendicular flow speed through the inflow apertures is more than five times that of an inlet flow speed of fluid flowing into the cold plate lid through the fluid inlet; and/or
the cold plate lid extends horizontally across the rear surface of the at least one semiconductor chip along an x-y plane and extends in a direction perpendicular to the rear surface of the at least one semiconductor chip along a z plane, wherein the cold plate lid has a first dimension extending along an x direction of the x-y plane, a second dimension extending along a y direction of the x-y plane, and a third dimension extending along the z plane, wherein the first dimension and the second dimension are each ten or more times greater than the third dimension; and/or
the cold plate lid further comprises an edge that is laterally adjacent the at least one semiconductor chip and extends around a periphery of the at least one semiconductor chip; and/or
the cold plate lid is thermally bonded to the at least one semiconductor chip using a thermal interface material; and/or
the at least one semiconductor chip comprises at least one high compute integrated circuit chip and a memory chip positioned adjacent one another; and/or
the at least one semiconductor chip is a plurality of semiconductor chips, and wherein the chip package further comprises a reconstituted wafer comprised of the plurality of semiconductor chips embedded within an overmold; and/or
the outer housing further comprises a top plate overlying a top surface of the flow plate and a base plate underlying the bottom surface of the flow plate, and wherein the base plate and the flow plate are integrally formed, and wherein the cold plate lid is sealed except for the fluid inlet and the fluid outlet.

According to another aspect of the disclosure, a chip package includes a chip subassembly and a cooling system. The chip subassembly includes a package substrate, terminals disposed at a surface of the package substrate, and a plurality of semiconductor chips that each have a top surface, an opposed rear surface, and edges extending therebetween. The cooling system may be bonded to the package substrate of the chip subassembly and thermally bonded to rear surfaces of the plurality of semiconductor chips. The cooling system may include a main body that includes a base plate, a top plate and an intermediate flow plate. The base plate may have a major surface bonded to the rear surfaces of the plurality of semiconductor chips and a circumferential edge laterally adjacent and extending around the plurality of semiconductor chips. The top plate may overlie the base plate. The intermediate flow plate may be positioned between the top and base plates and have a plurality of inflow apertures that extend between top and bottom surfaces of the intermediate flow plate so that fluid flowing across intermediate flow plate may flow through the inflow apertures and in a direction perpendicular to the base plate; and/or
the base plate, the top plate, and the intermediate flow plate are discrete components attached to one another; and/or
the main body further comprises a fluid inlet and a fluid outlet, and wherein the main body is sealed, except for the fluid inlet and the fluid outlet and wherein the base plate is attached to the package substrate; and/or
the base plate, the top plate, and the intermediate flow plate are integrally formed as a single unit; and/or
the base plate and the intermediate flow plate are integrally formed as a single unit; and/or
the cooling system further includes a first fluid chamber, a second heat exchange chamber, and a cooling elements. The first fluid chamber may be formed in a space between the base plate and the intermediate flow plate and extending around a periphery of the semiconductor chips. The second heat exchange chamber may be formed between the intermediate flow plate and the base plate and receiving fluid from the first fluid chamber. The cooling elements may be positioned within the second heat exchange chamber to assist with dissipation of heat within the second heat exchange chamber; and/or
the cooling system is bonded to at least some of the plurality of semiconductor chips with a thermal interface material; and/or
the chip package further comprises a reconstituted wafer comprised of the plurality of semiconductor chips embedded within an overmold.

Unless otherwise stated, the foregoing alternative examples are not mutually exclusive, but may be implemented in various combinations to achieve unique advantages. As these and other variations and combinations of the features discussed above can be utilized without departing from the subject matter defined by the claims, the foregoing description should be taken by way of illustration rather than by way of limitation of the subject matter defined by the claims. In addition, the provision of the examples described herein, as well as clauses phrased as "such as," "including," and the like, should not be interpreted as limiting the subject matter of the claims to the specific examples; rather, the examples are intended to illustrate only one of many possible implementations. Further, the same or similar reference numbers in different drawings can identify the same or similar elements.

## Claims

1. A semiconductor chip package comprising:
a package substrate having terminals disposed at a surface;
at least one semiconductor chip having a front surface bonded to the package substrate and an opposed rear surface; and
a cold plate lid configured to cool the at least one semiconductor chip and minimize warpage of the package substrate, the cold plate lid being bonded to the package substrate and thermally bonded to the rear surface of the at least one semiconductor chip, the cold plate lid further comprising:
an outer housing defining an interior space and having a bottom surface bonded to the at least one semiconductor chip;
a fluid inlet and a fluid outlet in communication with the interior space; and
a flow plate positioned within the interior space and dividing the interior space into an upper chamber and a lower chamber, the flow plate having a plurality of inflow apertures extending between top and bottom surfaces of the flow plate so that fluid flowing into the interior space flows from the upper chamber through the apertures and into the lower chamber in a direction perpendicular to the rear surface of the semiconductor chip.

2. The semiconductor chip package of claim 1, wherein the flow plate further includes an inflow region, an outflow region, and a flow wall separating the inflow and outflow regions; and/or
the flow plate further includes a plurality of outflow apertures positioned within the outflow region, and wherein the inflow region is located on a central portion of the flow plate and between the plurality of outflow apertures extending along an edge of the flow plate.

3. The semiconductor chip package of any one of claims 1-2, further comprising microjets positioned adjacent the inflow apertures, the microjets configured to increase a perpendicular flow speed of fluid traveling through the microjets and direct a flow direction of the fluid within cold plate lid in a direction perpendicular to a front or rear surface of the at least one semiconductor chip, such that the perpendicular flow speed is greater than a flow speed through the fluid inlet of the cold plate lid; and
wherein optionally the perpendicular flow speed through the inflow apertures is more than five times that of an inlet flow speed of fluid flowing into the cold plate lid through the fluid inlet.

4. The semiconductor chip package of any one of claims 1-3, wherein the cold plate lid extends horizontally across the rear surface of the at least one semiconductor chip along an x-y plane and extends in a direction perpendicular to the rear surface of the at least one semiconductor chip along a z plane, wherein the cold plate lid has a first dimension extending along an x direction of the x-y plane, a second dimension extending along a y direction of the x-y plane, and a third dimension extending along the z plane, wherein the first dimension and the second dimension are each ten or more times greater than the third dimension.

5. The semiconductor chip package of any one of claims 1-4, wherein the cold plate lid further comprises an edge that is laterally adjacent the at least one semiconductor chip and extends around a periphery of the at least one semiconductor chip.

6. The semiconductor chip package of any one of claims claim 1-5, wherein the cold plate lid is thermally bonded to the at least one semiconductor chip using a thermal interface material; and/or.
the at least one semiconductor chip comprises at least one high compute integrated circuit chip and a memory chip positioned adjacent one another.

7. The semiconductor chip package of any one of claims 1-6, wherein the at least one semiconductor chip is a plurality of semiconductor chips, and wherein the chip package further comprises a reconstituted wafer comprised of the plurality of semiconductor chips embedded within an overmold.

8. The semiconductor chip package of any one of claims 1-7, wherein the outer housing further comprises a top plate overlying a top surface of the flow plate and a base plate underlying the bottom surface of the flow plate, and wherein the base plate and the flow plate are integrally formed, and wherein the cold plate lid is sealed except for the fluid inlet and the fluid outlet.

9. A system comprising:
a printed circuit board; and
the semiconductor chip package of any one of claims 1-8, wherein the terminals are bonded to the printed circuit board.

10. A chip package comprising:
a chip subassembly having:
a package substrate;
terminals disposed at a surface of the package substrate; and
a plurality of semiconductor chips each having a top surface, an opposed rear surface, and edges extending therebetween; and
a cooling system bonded to the package substrate of the chip subassembly and thermally bonded to rear surfaces of the plurality of semiconductor chips, the cooling system comprising a main body, the main body comprising:
a base plate having a major surface bonded to the rear surfaces of the plurality of semiconductor chips and a circumferential edge laterally adjacent and extending around the plurality of semiconductor chips;
a top plate overlying the base plate; and
an intermediate flow plate positioned between the top and base plates, the intermediate flow plate having a plurality of inflow apertures extending between top and bottom surfaces of the intermediate flow plate so that fluid flowing across intermediate flow plate may flow through the inflow apertures and in a direction perpendicular to the base plate.

11. The chip package of claim 10, wherein the base plate, the top plate, and the intermediate flow plate are discrete components attached to one another.

12. The chip package of any one of claims 10-11, wherein the main body further comprises a fluid inlet and a fluid outlet, and wherein the main body is sealed, except for the fluid inlet and the fluid outlet and wherein the base plate is attached to the package substrate; and/or
wherein the base plate, the top plate, and the intermediate flow plate are integrally formed as a single unit; and/or
wherein the base plate and the intermediate flow plate are integrally formed as a single unit.

13. The chip package of any one of claims 10-12, wherein the cooling system further comprises:
a first fluid chamber formed in a space between the base plate and the intermediate flow plate and extending around a periphery of the semiconductor chips;
a second heat exchange chamber formed between the intermediate flow plate and the base plate, the second heat exchange chamber receiving fluid from the first fluid chamber; and
cooling elements positioned within the second heat exchange chamber to assist with dissipation of heat within the second heat exchange chamber.

14. The chip package of any one of claims 10-13, wherein the cooling system is bonded to at least some of the plurality of semiconductor chips with a thermal interface material; and/or
the chip package further comprises a reconstituted wafer comprised of the plurality of semiconductor chips embedded within an overmold.

15. A method of manufacturing a chip package comprising:
attaching first and second semiconductor chips to a carrier substrate;
applying a thermal interface material to a bonding surface of the first and semiconductor chips;
bonding a cold plate lid to the bonding surface of the first and second semiconductor chips;
filling a space between exposed surfaces of the carrier substrate and a bottom surface of the cold plate lid and adjacent edges of the first and second semiconductor chips with an overmold;
removing the carrier substrate; and
providing terminals to the chip package; and/or
bonding the cold plate lid to the overmold; and/or
underbonding the cold plate lid to a package substrate supporting the first and second semiconductor chips.
